# EUROPEAN PATENT APPLICATION

(11) **EP 3 173 436 A1**
(43) Date of publication of application: **31.05.2017**
(21) Application number: 15825116.5
(22) Date of filing: 15.07.2015
(51) Int. Cl.: C08G 61/12, H01L 29/786, H01L 51/05, H01L 51/30, H01L 51/46, H01L 51/50

(54) **POLYMERIC COMPOUND AND ORGANIC SEMICONDUCTOR DEVICE INCLUDING SAME**

(30) Priority: 23.07.2014 JP 2014149521
(71) Applicant: Sumitomo Chemical Company Limited, Tokyo 104-8260 (JP)
(72) Inventor: YOSHIKAWA, Eiji, Tsukuba-shi Ibaraki 300-3294 (JP); KASHIKI, Tomoya, Tsukuba-shi Ibaraki 300-3294 (JP)
(74) Representative: Duckworth, Timothy John
(86) International application number: PCT/JP2015/070236
(87) International publication number: WO 2016/013461

(57) **Abstract**

A polymer compound comprising a structural unit represented by the formula (1): 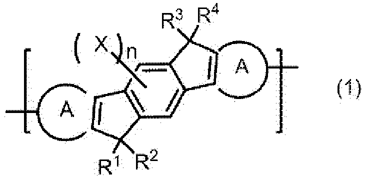 [wherein
R¹, R², R³ and R⁴ each independently represent an alkyl group, an aryl group or a monovalent heterocyclic group, and these groups optionally have a substituent.
Two rings A may be the same or different, and represent a thiophene ring, a benzothiophene ring or a thienothiophene ring. n represents 1 or 2, and X represents a halogen atom, an alkyl group, an alkoxy group, an alkylthio group, an amino group, an aryl group, a monovalent heterocyclic group, an alkenyl group or an alkynyl group, and these groups optionally have a substituent. When n is 2, two groups X may be the same or different.].

## Description

### Technical Field

The present invention relates to a polymer compound and an organic semiconductor device using the same.

### Background Art

An organic film solar battery using a polymer compound in an active layer can skip a high temperature process and a high vacuum process used in a process of producing a silicon solar battery and can be possibly produced only by a coating process at low cost and is recently attracting attention. As the polymer compound used in an organic film solar battery, a polymer compound composed of a structural unit (A) and a structural unit (B) represented by the following formulae is suggested (Non-patent document 1).

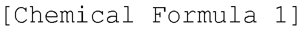

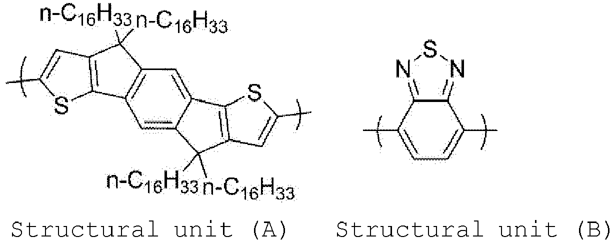

### Prior Art Document

### Non-patent Document

Non-patent document 1: Macromolecules 2011, 44, 6649-6652

### Summary of the Invention

However, an organic film solar battery having an organic film containing the above-described polymer compound has not necessarily sufficient fill factor.

Then, the present invention has an object of providing a polymer compound which is useful for production of an organic film solar battery excellent in fill factor.

### Means for Solving the Problem

The present invention is as described below.
[1] A polymer compound comprising a structural unit represented by the formula (1) : 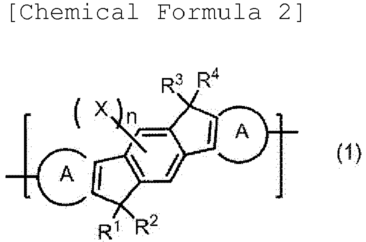 [wherein
   R¹, R², R³ and R⁴ each independently represent an alkyl group, an aryl group or a monovalent heterocyclic group, and these groups optionally have a substituent.

   Two rings A may be the same or different, and represent a thiophene ring, a benzothiophene ring or a thienothiophene ring. n represents 1 or 2, and X represents a halogen atom, an alkyl group, an alkoxy group, an alkylthio group, an amino group, an aryl group, a monovalent heterocyclic group, an alkenyl group or an alkynyl group, and these groups optionally have a substituent. When n is 2, two groups X may be the same or different.].
[2] The polymer compound according to [1], wherein the structural unit represented by the formula (1) is a structural unit represented by the formula (2): 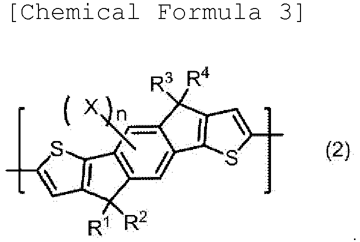 [wherein R¹, R², R³, R⁴, n and X represent the same meaning as described above.].
[3] An organic film comprising the polymer compound according to [1] or [2].
[4] An organic semiconductor device comprising a first electrode, a second electrode and the organic film according to [3].
[5] The organic semiconductor device according to [4], wherein the device is any of a photoelectric conversion device, an organic transistor, an organic electroluminescent device, an organic field effect type transistor sensor and an organic conductivity modulation type sensor.
[6] The organic semiconductor device according to [5], wherein the device is a photoelectric conversion device.

### Brief Explanation of Drawing

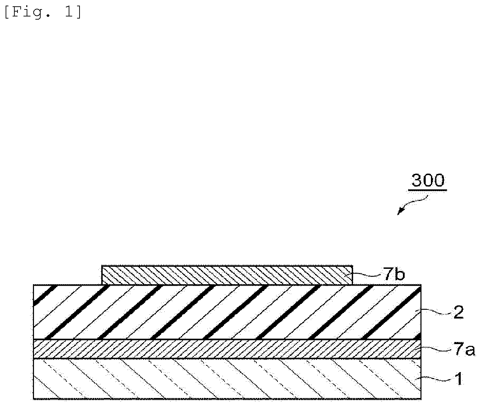

Fig. 1 is a schematic cross-sectional view showing one example of the organic film solar battery of the present invention.

### Modes for Carrying Out the Invention

Suitable embodiments of the present invention will be illustrated in detail below, if necessary referring to drawings. In explanation of the drawings, the same element is endowed with the same sign, and duplicated explanations are omitted.

### <Polymer compound>

### (First structural unit)

The polymer compound of the present invention is a polymer compound comprising a structural unit represented by the formula (1) (hereinafter, referred to as "first structural unit" in some cases). The first structural units may be contained each singly or two or more of them may be contained in the polymer compound. The polymer compound of the present invention is preferably a conjugated polymer compound.

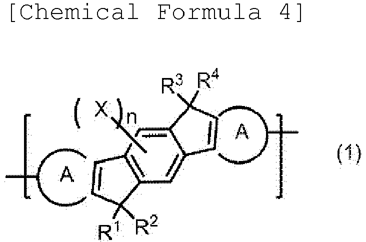

In the formula (1), two rings A may be the same or different and represent a thiophene ring, a benzothiophene ring or a thienothiophene ring, and a thiophene ring is preferable.

In the formula (1), the alkyl group represented by R¹, R², R³ and R⁴ may be any of a linear alkyl group and a branched alkyl group, and may also be a cycloalkyl group. The alkyl group has a number of carbon atoms of usually 1 to 30 (in the case of a branched alkyl group and a cycloalkyl group, usually 3 to 30), preferably 1 to 20 (in the case of a branched alkyl group and a cycloalkyl group, 3 to 20). The above-described number of carbon atoms does not include the number of carbon atoms of the substituent.

Specific examples of the alkyl group include linear alkyl groups such as a methyl group, an ethyl group, a n-propyl group, a n-butyl group, a n-hexyl group, a n-octyl group, a n-dodecyl group, a n-hexadecyl group and the like, branched alkyl groups such as an isopropyl group, an isobutyl group, a sec-butyl group, a tert-butyl group, a 2-ethylhexyl group, a 3,7-dimethyloctyl group and the like, and cycloalkyl groups such as a cyclopentyl group, a cyclohexyl group and the like.

The alkyl group optionally has a substituent, and the substituent which the alkyl group optionally has includes an alkoxy group, an aryl group, a halogen atom and the like. Specific examples of the alkyl group having a substituent include a methoxyethyl group, a benzyl group, a trifluoromethyl group, a perfluorohexyl group and the like.

The aryl group represented by R¹, R², R³ and R⁴ is an atomic group remaining after removing from an aromatic hydrocarbon one hydrogen atom bonding directly to a carbon atom constituting the ring, and includes a group having a condensed ring and a group obtained by directly bonding two or more groups selected from the group consisting of an independent benzene ring and a condensed ring.

The aryl group has a number of carbon atoms of usually 6 to 30, preferably 6 to 20. The above-described number of carbon atoms does not include the number of carbon atoms of the substituent.

Specific examples of the aryl group include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 4-phenylphenyl group and the like.

The aryl group optionally has a substituent, and the substituent which the aryl group optionally has includes an alkyl group, an alkoxy group, an alkylthio group, a monovalent heterocyclic group, a halogen atom and the like. The aryl group having a substituent includes a 4-hexadecylphenyl group, a 4-dodecylphenyl group, a 4-octylphenyl group, a 4-hexylphenyl group, a 4-octyloxyphenyl group, a 3,5-dimethoxyphenyl group, a pentafluorophenyl group and the like. When the aryl group has a substituent, the substituent is preferably an alkyl group.

The monovalent heterocyclic group represented by R¹, R², R³ and R⁴ is an atomic group remaining after removing from a heterocyclic compound one hydrogen atom bonding directly to a carbon atom constituting the ring, and includes a group having a condensed ring and a group obtained by directly bonding two or more groups selected from the group consisting of an independent heterocyclic group and a condensed ring. The monovalent heterocyclic group has a number of carbon atoms of usually 2 to 30, preferably 3 to 20. The above-described number of carbon atoms does not include the number of carbon atoms of the substituent.

Specific examples of the monovalent heterocyclic group include a 2-furyl group, a 3-furyl group, a 2-thienyl group, a 3-thienyl group, a 2-pyrrolyl group, a 3-pyrrolyl group, a 2-oxazolyl group, a 2-thiazolyl group, a 2-imidazolyl group, a 2-pyridyl group, a 3-pyridyl group, a 4-pyridyl group, a 2-benzofuryl group, a 2-benzothienyl group, a 2-thienothienyl group, a 4-(2,1,3-benzothiadiazolyl) group and the like.

The monovalent heterocyclic group optionally has a substituent, and the substituent which the monovalent heterocyclic group optionally has includes an alkyl group, an alkoxy group, an alkylthio group, an aryl group, a halogen atom and the like. The monovalent heterocyclic group having a substituent includes a 5-octyl-2-thienyl group, a 5-phenyl-2-furyl group and the like. When the monovalent heterocyclic group has a substituent, the substituent is preferably an alkyl group.

The halogen atom represented by X includes, for example, a fluorine atom, a chlorine atom, a bromine atom and an iodine atom, and the halogen atom is preferably a fluorine atom since side reactions are less likely to occur in a polymerization reaction.

The alkyl group represented by X may be any of a linear alkyl group and a branched alkyl group, and may also be a cycloalkyl group. The alkyl group has a number of carbon atoms of usually 1 to 30 (in the case of a branched alkyl group and a cycloalkyl group, usually 3 to 30), preferably 1 to 20 (in the case of a branched alkyl group and a cycloalkyl group, 3 to 20).

The alkyl group includes, for example, linear alkyl groups such as a methyl group, an ethyl group, a n-propyl group, a n-butyl group, a n-hexyl group, a n-octyl group, a n-undecyl group, a n-dodecyl group, a n-pentadecyl group, a n-hexadecyl group, a n-heptadecyl group and the like, branched alkyl groups such as an isopropyl group, an isobutyl group, a sec-butyl group, a tert-butyl group, a 2-ethylhexyl group, a 3,7-dimethyloctyl group and the like, and cycloalkyl groups such as a cyclopentyl group, a cyclohexyl group and the like.

The alkyl group optionally has a substituent, and the substituent includes, for example, an alkoxy group, an aryl group and a halogen atom. The alkyl group having a substituent includes, for example, a methoxyethyl group, a benzyl group, a trifluoromethyl group and a perfluorohexyl group.

The alkoxy group represented by X may be any of a linear alkoxy group and a branched alkoxy group, and may also be a cycloalkoxy group. The alkoxy group has a number of carbon atoms of usually 1 to 30 (in the case of a branched alkoxy group and a cycloalkoxy group, usually 3 to 30), preferably 1 to 20 (in the case of a branched alkoxy group and a cycloalkoxy group, 3 to 20).

The alkoxy group includes, for example, linear alkoxy groups such as a methoxy group, an ethoxy group, a n-propyloxy group, a n-butyloxy group, a n-hexyloxy group, a n-octyloxy group, a n-dodecyloxy group, a n-hexadecyloxy group and the like, branched alkoxy groups such as an isopropyloxy group, an isobutyloxy group, a sec-butyloxy group, a tert-butyloxy group, a 2-ethylhexyloxy group, a 3,7-dimethyloctyloxy group and the like, and cycloalkoxy groups such as a cyclopentyloxy group, a cyclohexyloxy group and the like.

The alkoxy group optionally has a substituent, and the substituent includes, for example, an alkoxy group, an aryl group and a halogen atom.

The alkylthio group represented by X may be any of a linear alkylthio group and a branched alkylthio group, and may also be a cycloalkylthio group. The alkylthio group has a number of carbon atoms of usually 1 to 30 (in the case of a branched alkylthio group and a cycloalkylthio group, usually 3 to 30), preferably 1 to 20 (in the case of a branched alkylthio group and a cycloalkylthio group, 3 to 20).

The alkylthio group includes, for example, linear alkylthio groups such as a methylthio group, an ethylthio group, a n-propylthio group, a n-butylthio group, a n-hexylthio group, a n-octylthio group, a n-dodecylthio group, a n-hexadecylthio group and the like, branched alkylthio groups such as an isopropylthio group, an isobutylthio group, a sec-butylthio group, a tert-butylthio group, a 2-ethylhexylthio group, a 3,7-dimethyloctylthio group and the like, and cycloalkylthio groups such as a cyclopentylthio group, a cyclohexylthio group and the like.

The alkylthio group optionally has a substituent, and the substituent includes, for example, an alkoxy group, an aryl group and a halogen atom.

The amino group represented by X optionally has a substituent. The substituent which the amino group optionally has includes, for example, an alkyl group and an aryl group. The amino group having a substituent includes, for example, a dimethylamino group, a diethylamino group, a diisopropylamino group and a diphenylamino group. The amino group has a number of carbon atoms of usually 0 to 30, preferably 2 to 30.

The aryl group represented by X has a number of carbon atoms of usually 6 to 30, preferably 6 to 20. The above-described number of carbon atoms does not include the number of carbon atoms of the substituent.

Specific examples of the aryl group include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 4-phenylphenyl group and the like.

The aryl group optionally has a substituent, and the substituent which the aryl group optionally has includes an alkyl group, an alkoxy group, an alkylthio group, a monovalent heterocyclic group, a halogen atom and the like. The aryl group having a substituent includes a 4-hexadecylphenyl group, a 4-dodecylphenyl group, a 4-octylphenyl group, a 4-hexylphenyl group, a 4-octyloxyphenyl group, a 3,5-dimethoxyphenyl group, a pentafluorophenyl group and the like. When the aryl group has a substituent, the substituent is preferably an alkyl group.

The monovalent heterocyclic group represented by X has a number of carbon atoms of usually 2 to 30, preferably 3 to 20. The above-described number of carbon atoms does not include the number of carbon atoms of the substituent.

Specific examples of the monovalent heterocyclic group include a 2-furyl group, a 3-furyl group, a 2-thienyl group, a 3-thienyl group, a 2-pyrrolyl group, a 3-pyrrolyl group, a 2-oxazolyl group, a 2-thiazolyl group, a 2-imidazolyl group, a 2-pyridyl group, a 3-pyridyl group, a 4-pyridyl group, a 2-benzofuryl group, a 2-benzothienyl group, a 2-thienothienyl group, a 4-(2,1,3-benzothiadiazolyl) group and the like.

The monovalent heterocyclic group optionally has a substituent, and the substituent which the monovalent heterocyclic group optionally has includes an alkyl group, an alkoxy group, an alkylthio group, an aryl group, a halogen atom and the like. The monovalent heterocyclic group having a substituent includes a 5-octyl-2-thienyl group, a 5-phenyl-2-furyl group and the like. When the monovalent heterocyclic group has a substituent, the substituent is preferably an alkyl group.

The alkenyl group represented by X may be any of a linear alkenyl group and a branched alkenyl group, and may also be a cycloalkenyl group. The alkenyl group has a number of carbon atoms of usually 2 to 30 (in the case of a branched alkenyl group and a cycloalkenyl group, usually 3 to 30), preferably 2 to 20 (in the case of a branched alkenyl group and a cycloalkenyl group, 3 to 20).

The alkenyl group includes, for example, a vinyl group, a 1-propenyl group, a 2-propenyl group, a 1-hexenyl group, a 1-dodecenyl group, a 1-hexadecenyl group and a 1-cyclohexenyl group.

The alkenyl group optionally has a substituent, and the substituent includes, for example, an aryl group, a halogen atom and a silyl group.

The alkynyl group represented by X may be any of a linear alkynyl group and a branched alkynyl group. The alkynyl group has a number of carbon atoms of usually 2 to 30 (in the case of a branched alkynyl group, usually 4 to 30), preferably 2 to 20 (in the case of a branched alkynyl group, 4 to 20). The above-described number of carbon atoms does not include the number of carbon atoms of the substituent.

The alkynyl group includes, for example, an ethynyl group, a 1-propynyl group, a 1-hexynyl group, a 1-dodecynyl group and a 1-hexadecynyl group.

The alkynyl group optionally has a substituent, and the substituent includes, for example, an aryl group, a halogen atom and a silyl group.

A silyl group as the substituent which the alkenyl group and the alkynyl group optionally have optionally has a substituent. The substituent which a silyl group optionally has includes, for example, an alkyl group, a cycloalkyl group and an aryl group. The silyl group having a substituent includes, for example, a trimethylsilyl group, a triethylsilyl group, a triisopropylsilyl group, a tert-butyldimethylsilyl group, a t-butyldiphenylsilyl group and a triphenylsilyl group. The silyl group has a number of carbon atoms of usually 0 to 30, preferably 3 to 30.

It is preferable that two rings A are the same and it is more preferable that both rings A represent a thiophene ring, since synthesis of the polymer compound of the present invention is easy.

It is preferable that the structural unit represented by the formula (1) is a structural unit represented by the formula (2), since an organic film solar battery produced by using the polymer compound of the present invention is more excellent in fill factor.

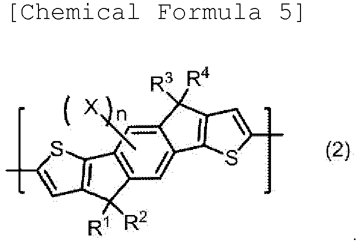

In the formula, R¹, R², R³, R⁴, n and X represent the same meaning as described above.

X is preferably an alkyl group, an alkoxy group, an aryl group, an amino group, an aryl group, a monovalent heterocyclic group, an alkenyl group or an alkynyl group, more preferably an alkyl group or an alkoxy group, since an organic film solar battery produced by using the polymer compound of the present invention is more excellent in fill factor. These groups optionally have a substituent. n is preferably 2, and when n is 2, it is more preferable that groups X are the same and it is further preferable that the same two groups X represent an alkyl group or an alkoxy group.

It is preferable that R¹, R², R³ and R⁴ each independently represent an alkyl group or an aryl group, since an organic film solar battery produced by using the polymer compound of the present invention is more excellent in fill factor.

It is more preferable that R¹, R², R³ and R⁴ are the same and it is further preferable that all R¹, R², R³ and R⁴ represent an alkyl group or an aryl group, since synthesis of the polymer compound of the present invention is easy.

The structural unit represented by the formula (1) includes, for example, structural units represented by the formula (1-1) to the formula (1-20).

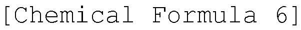

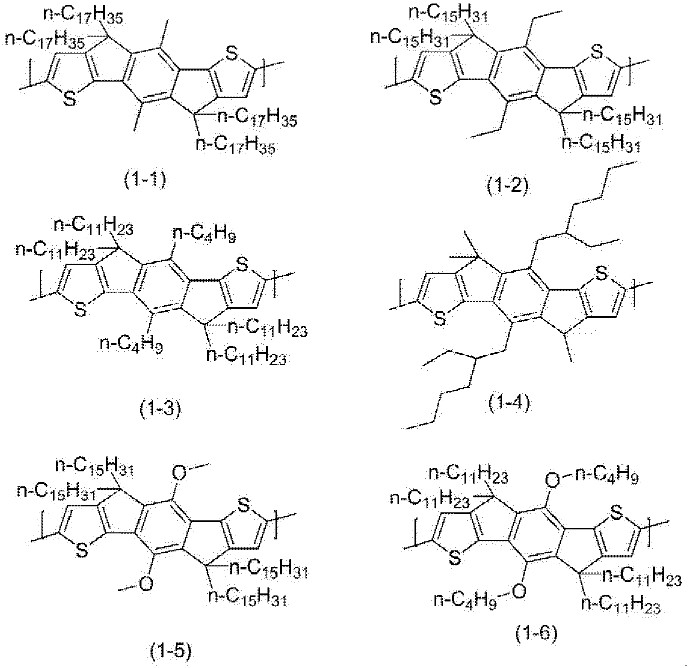

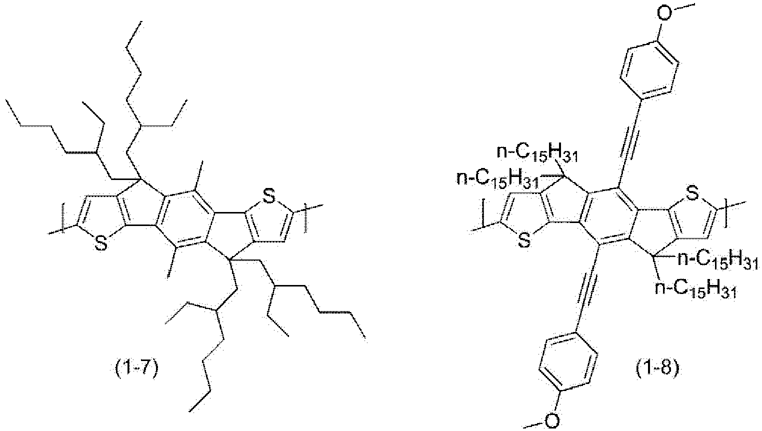

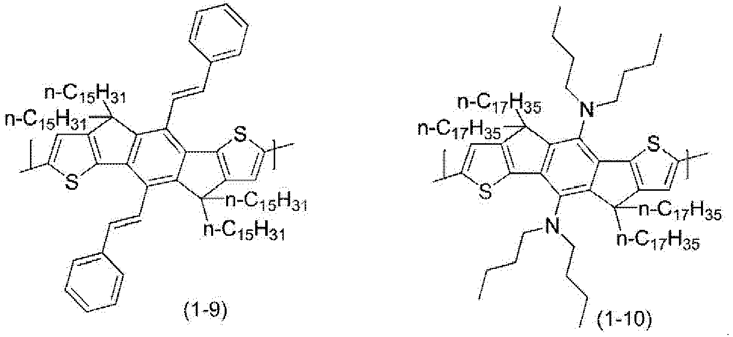

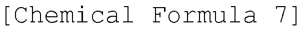

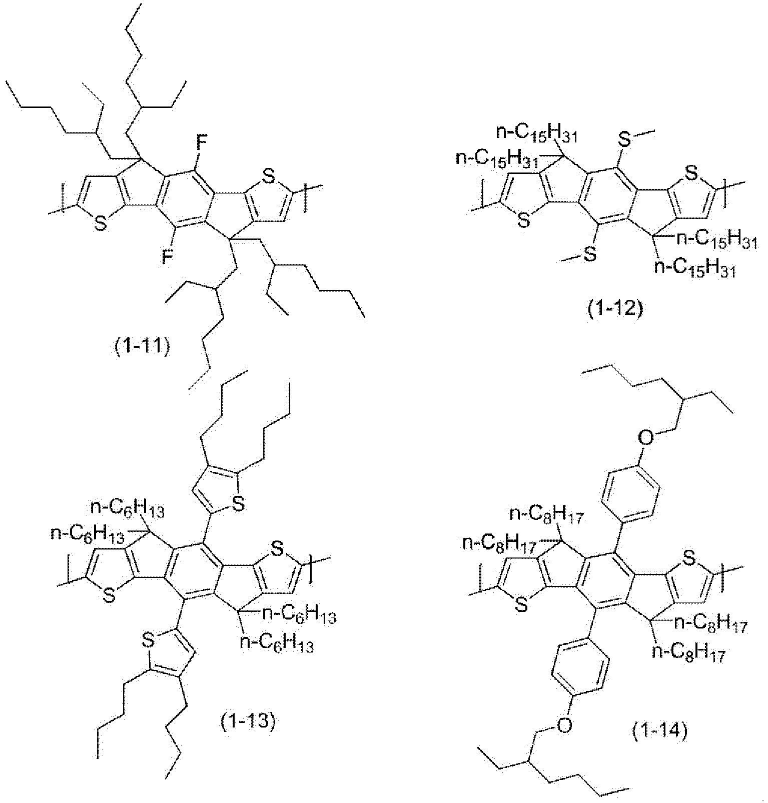

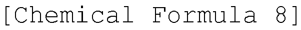

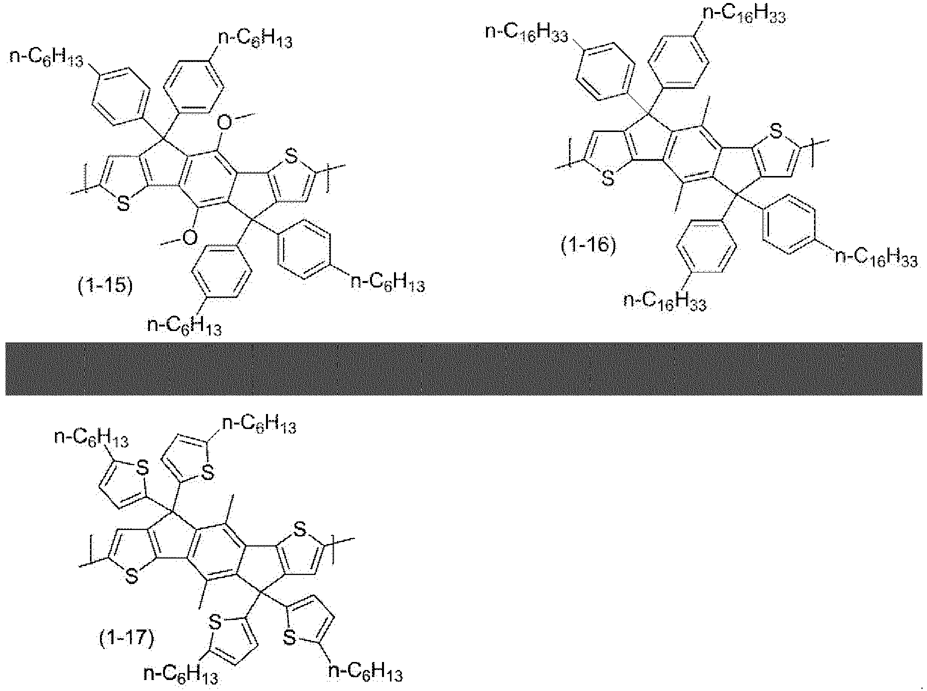

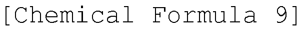

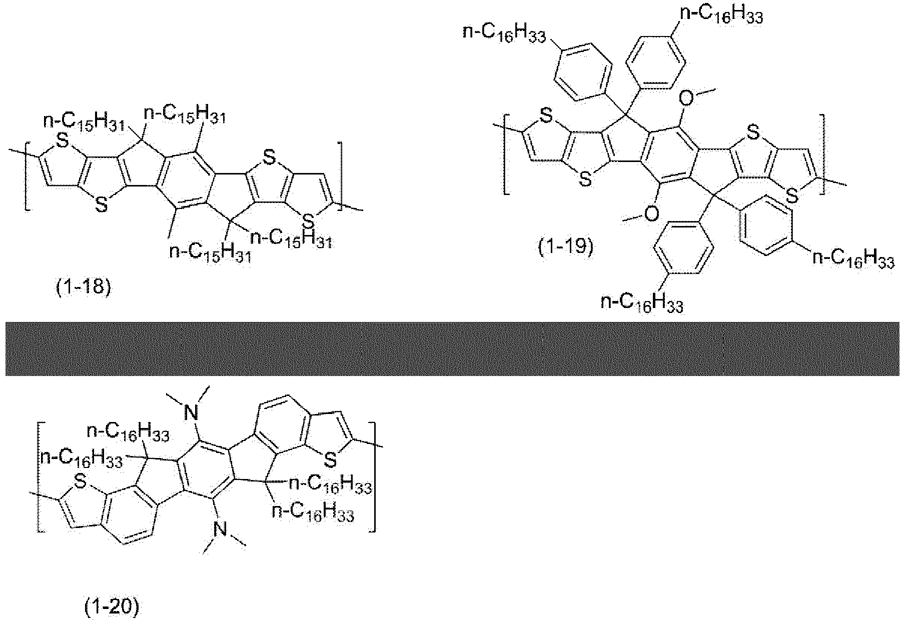

### (Second structural unit)

It is preferable that the polymer compound of the present invention further contains a structural unit represented by the formula (4) (different from the structural unit represented by the formula (1) described above) (hereinafter, referred to as "second structural unit" in some cases) in addition to the structural unit represented by the formula (1). The second structural units may be contained each singly or two or more of them may be contained in the polymer compound.

When the polymer compound of the present invention contains a second structural unit, the mole fraction of the second structural unit is preferably 20 to 80 mol%, more preferably 40 to 60 mol% with respect to the total amount of the first structural unit and the second structural unit.

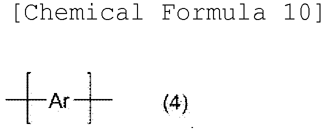

In the formula (4), Ar represents an arylene group or a divalent heterocyclic group, and these groups optionally have a substituent.

When the polymer compound of the present invention contains a second structural unit, it is preferable that a structural unit represented by the formula (1) and a structural unit represented by the formula (4) are conjugated.

In the present specification, conjugated is indicative of a condition in which an unsaturated bond-a single bond-an unsaturated bond are linked in this order, two π bonds of the π orbital are adjacent, respective π electrons are disposed parallel, and π electrons do not localize on the unsaturated bond but π electrons spread onto the adjacent single bond to give delocalization of π electrons. The unsaturated bond denotes a double bond or a triple bond.

The arylene group is an atomic group remaining after removing from an aromatic hydrocarbon two hydrogen atoms bonding directly to carbon atoms constituting the ring and includes a group having a condensed ring, a group obtained by directly bonding two or more groups selected from the group consisting of an independent benzene ring and a condensed ring and a group obtained by bonding two or more groups selected from the group consisting of an independent benzene ring and a condensed ring via vinylene and the like. The arylene group has a number of carbon atoms of usually 6 to 60, preferably 6 to 20. The above-described number of carbon atoms does not include the number of carbon atoms of the substituent.

The arylene group optionally has a substituent, and the substituent includes, for example, an alkyl group, an alkoxy group, an alkylthio group, a monovalent heterocyclic group and a halogen atom. The definition and specific examples of these substituents are the same as the definition and specific examples of the alkyl group, the alkoxy group, the alkylthio group, the monovalent heterocyclic group and the halogen atom represented by X described above.

The arylene group includes, for example, arylene groups represented by the following formulae 1 to 12.

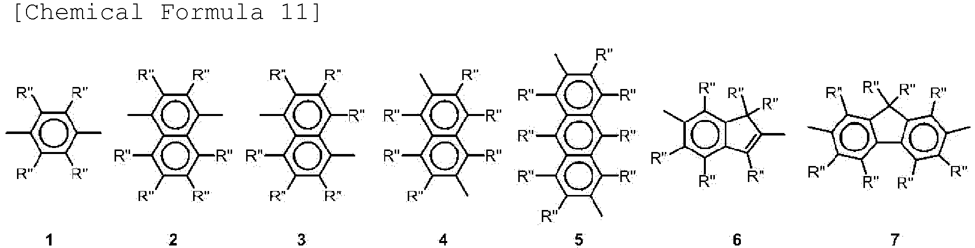

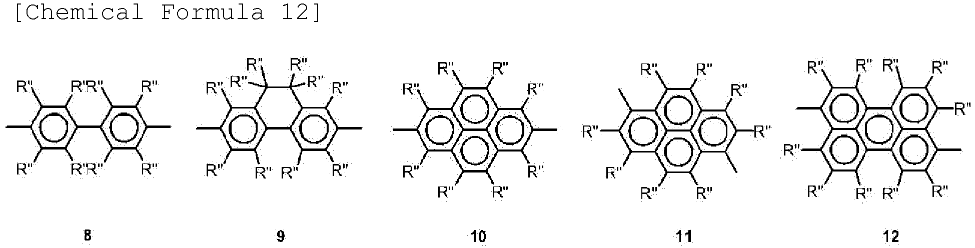

In the formulae 1 to 12, R'' represents a hydrogen atom, an alkyl group, an alkoxy group, an alkylthio group, an aryl group, a monovalent heterocyclic group or a halogen atom. A plurality of R'' may be the same or different.

The definition and specific examples of the alkyl group, the alkoxy group, the alkylthio group, the aryl group, the monovalent heterocyclic group and the halogen atom are the same as the definition and specific examples of the alkyl group, the alkoxy group, the alkylthio group, the aryl group, the monovalent heterocyclic group and the halogen atom represented by X described above.

The divalent heterocyclic group is an atomic group remaining after removing from a heterocyclic compound two hydrogen atoms bonding directly to carbon atoms or hetero atoms constituting the ring and includes a group having a condensed ring and a group obtained by directly bonding two or more groups selected from the group consisting of an independent heterocyclic group and a condensed ring. The divalent heterocyclic group has a number of carbon atoms of usually 2 to 30, preferably 3 to 20. The above-described number of carbon atoms does not include the number of carbon atoms of the substituent. The divalent heterocyclic group is preferably a divalent aromatic heterocyclic group.

The divalent heterocyclic group optionally has a substituent, and the substituent includes, for example, an alkyl group, an alkoxy group, an alkylthio group, an aryl group and a halogen atom. The definition and specific examples of these substituents are the same as the definition and specific examples of the alkyl group, the alkoxy group, the alkylthio group, the aryl group and the halogen atom represented by X described above.

The divalent heterocyclic group includes, for example, divalent heterocyclic groups represented by the following formulae 13 to 64.

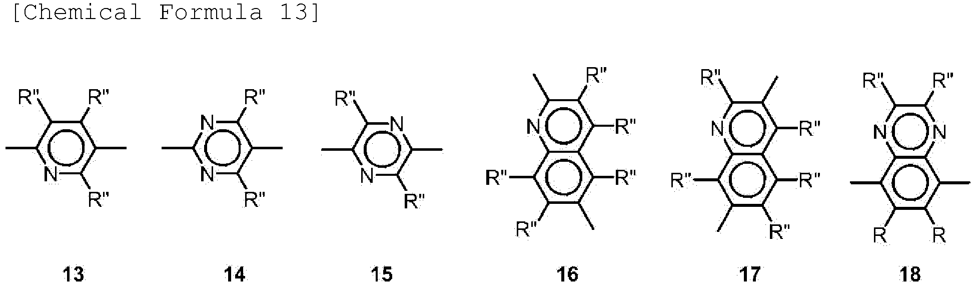

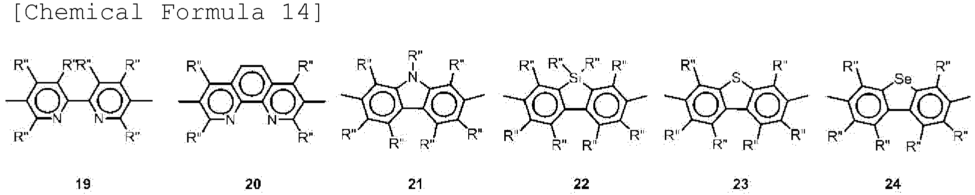

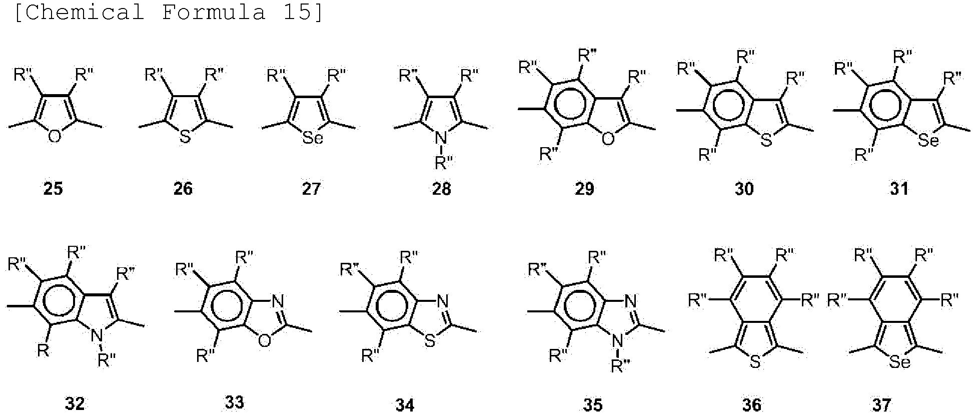

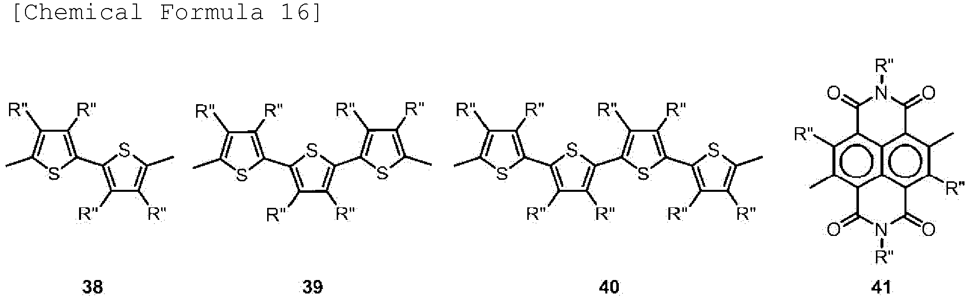

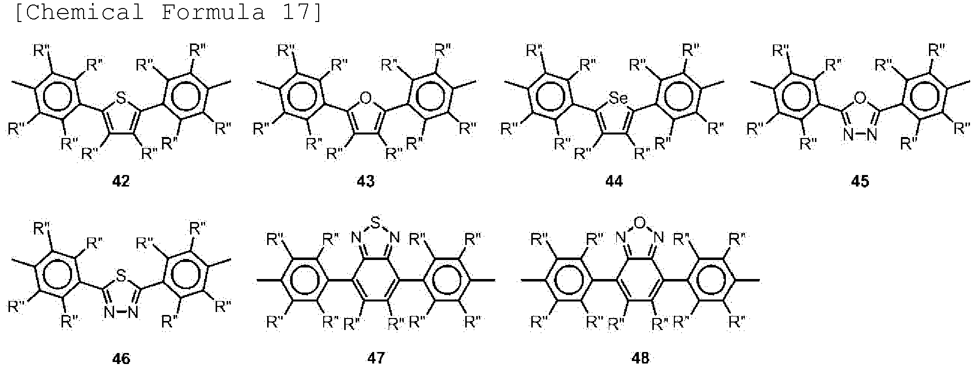

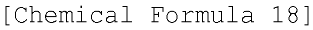

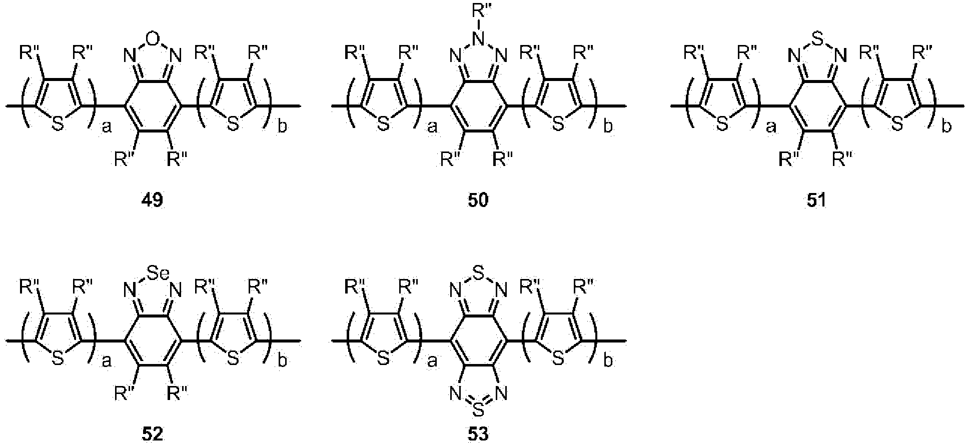

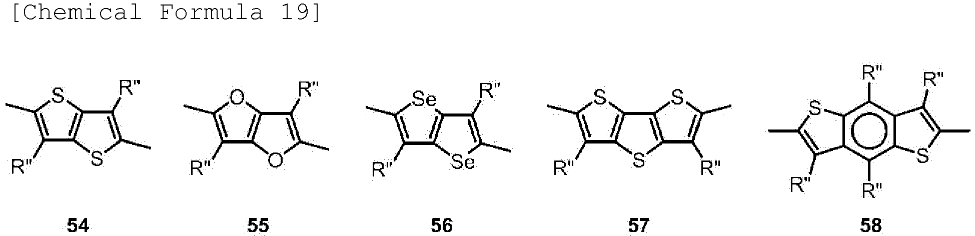

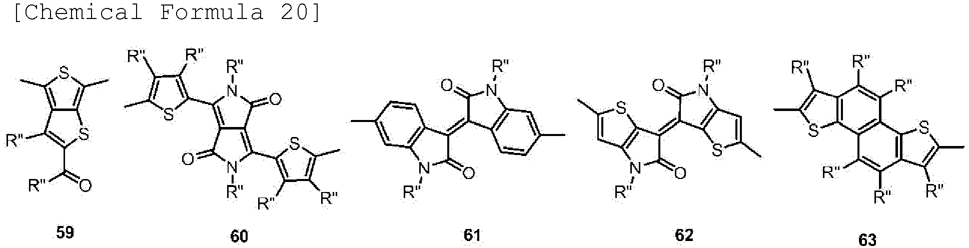

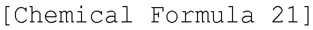

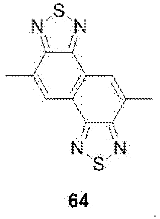

In the formulae 13 to 64, R'' represents the same meaning as described above. a and b each independently represent the number of repetition, and usually an integer of 0 to 5, preferably an integer of 0 to 3, more preferably 0 or 1.

The second structural unit is preferably a divalent heterocyclic group, more preferably a divalent heterocyclic group represented by the formula 49 to the formula 53, the formulae 59 to 62 and the formula 64, further preferably a divalent heterocyclic group represented by the formula 51 and the formula 64, since an organic film solar battery produced by using the polymer compound of the present invention is more excellent in fill factor.

### (Other structural unit)

The polymer compound of the present invention may contain other structural units than the first structural unit and the second structural unit described above (hereinafter, referred to as "other structural unit" in some cases). The other structural units may be contained each singly or two or more of them may be contained in the polymer compound.

The other structural unit includes, for example, a group represented by -CR^{c}=CR^{d}-, -C≡C-, a group represented by the formula: -CR^{g}₂-, a group represented by the formula: -C(=O)- and a group represented by the formula:

-C(=O)O-.

In the group represented by -CR^{c}=CR^{d}-, R^{c}, R^{d} and R^{g} each independently represent a hydrogen atom, an alkyl group, a cycloalkyl group, an aryl group, a monovalent aromatic heterocyclic group, a halogen atom or a cyano group, and of these groups, an alkyl group, a cycloalkyl group, an aryl group and a monovalent aromatic heterocyclic group each optionally have a substituent.

The substituent which R^{c}, R^{d} and R^{g} optionally have includes an alkyl group, a cycloalkyl group, an alkoxy group, a cycloalkoxy group, an alkylthio group, a cycloalkylthio group, an aryl group, a monovalent aromatic heterocyclic group, a halogen atom and the like, and of them, an alkyl group is preferable.

The polymer compound of the present invention has a polystyrene-equivalent number-average molecular weight (Mn) measured by gel permeation chromatography (hereinafter, referred to as "GPC") of usually 1×10³ to 1×10⁷. The number-average molecular weight is preferably 3×10³ or more, from the standpoint of forming a good film. The number-average molecular weight is preferably 1×10⁶ or less, from the standpoint of enhancing solubility in a solvent and making film formation easy.

The polymer compound of the present invention is one having high solubility in a solvent (preferably, an organic solvent), and specifically, it is preferable that it has solubility by which a solution containing the polymer compound of the present invention in an amount of 0.1 wt% or more can be prepared, it is more preferable that it has solubility by which a solution containing the polymer compound of the present invention in an amount of 0.4 wt% or more can be prepared.

In the polymer compound of the present invention, it is recommendable that at least one structural unit represented by the formula (1) is contained in the polymer compound, and it is preferable that three or more structural units are contained in the polymer compound, it is more preferable that five or more structural units are contained in the polymer compound.

In the polymer compound of the present invention, the total mole fraction of a first structural unit and a second structural unit with respect to all structural units constituting the polymer compound is preferably 50 mol% or more, more preferably 70 mol% or more, since more excellent carrier mobility is obtained. The upper limit of the total mole fraction of a first structural unit and a second structural unit with respect to all structural units constituting the polymer compound is 100 mol%.

The polymer compound of the present invention may be a homopolymer or a copolymer.

The polymer compound of the present invention may be any kind of copolymer, and for example, may be any of a block copolymer, a random copolymer, an alternate copolymer and a graft copolymer. The polymer compound of the present invention is preferably a copolymer of a structural unit represented by the formula (1) and a structural unit represented by the formula (4), more preferably an alternate copolymer of a structural unit represented by the formula (1) and a structural unit represented by the formula (4), since an organic film solar battery produced by using the polymer compound of the present invention is more excellent in fill factor. When a plurality of structural units represented by the formula (1) are present in the copolymer, they may be the same or different, and when a plurality of structural units represented by the formula (4) are present in the copolymer, they may be the same or different.

Specific examples of the structural unit which the alternate copolymer of a structural unit represented by the formula (1) and a structural unit represented by the formula (4) of the present invention has include the following structural units.

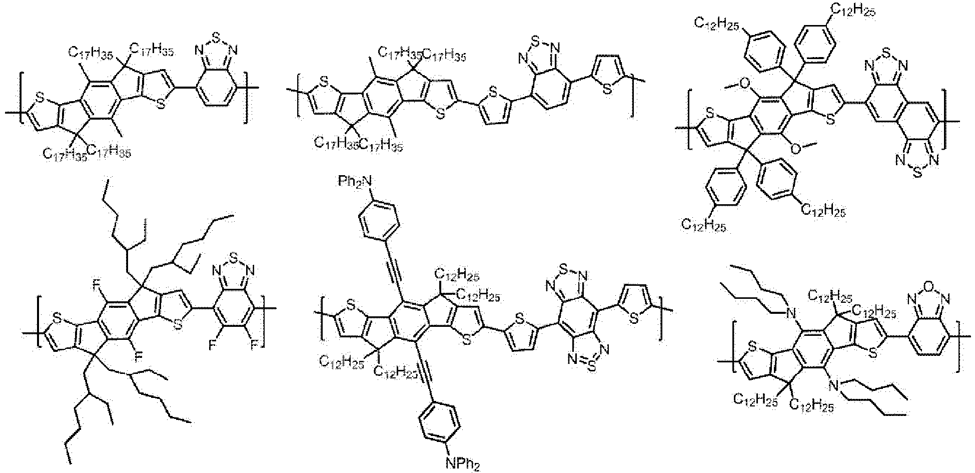

When a group showing activity on the polymerization reaction remains at the end of the molecular chain of the polymer compound of the present invention, there is a possibility of lowering of fill factor of an organic film solar battery produced by using the polymer compound. Therefore, it is preferable that the end of the molecular chain is composed of a stable group such as an aryl group, a monovalent aromatic heterocyclic group and the like.

### <Production method of polymer compound>

Next, a method of producing the polymer compound of the present invention will be illustrated.

The polymer compound of the present invention may be produced by any method, and for example, a compound represented by the formula: X¹¹-A¹¹-X¹² and a compound represented by the formula: X¹³-A¹²-X¹⁴ are, if necessary, dissolved in an organic solvent, with addition of a base as needed, subjected to known polymerization methods such as aryl coupling and the like using a suitable catalyst, thus, the polymer compound can be synthesized.

A¹¹ represents a structural unit represented by the formula (1), and A¹² represents a structural unit represented by the formula (4). X¹¹, X¹², X¹³ and X¹⁴ each independently represent a polymerization reactive group.

The polymerization reactive group includes, for example, a halogen atom, a borate residue, a boric acid residue and an organotin residue substituted with three alkyl groups. The boric acid residue denotes a group represented by -B(OH)₂.

The halogen atom as the polymerization reactive group includes, for example, a fluorine atom, a chlorine atom, a bromine atom and an iodine atom.

The borate residue as the polymerizable functional group denotes an atomic group obtained by removing from an ester of boronic acid (HB(OH)₂) a hydrogen atom bonded to its boron. The borate residue has a number of carbon atoms of usually 2 to 40. The borate residue includes, for example, groups represented by the following formulae.

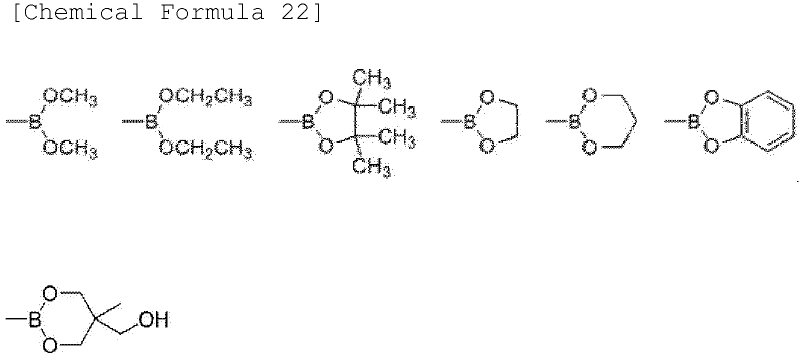

The organotin residue substituted with three alkyl groups (trialkyl stannyl group) as the polymerization reactive group includes, for example, an organotin residue substituted with three methyl groups and an organotin residue substituted with three butyl groups. The organotin residue has a number of carbon atoms of usually 3 to 30.

The above-described polymerization method such as aryl coupling and the like includes, for example, a method of polymerization by the Suzuki coupling reaction (Chemical Review, 1995, vol. 95, pp. 2457-2483) and a method of polymerization by the Stille coupling reaction (European Polymer Journal, 2005, vol. 41, pp. 2923-2933).

In the case of use of a nickel catalyst or a palladium catalyst such as in the Suzuki coupling reaction and the like, the polymerization reactive group is preferably a halogen atom, a borate residue or a boric acid residue, it is more preferably a bromine atom, an iodine atom or a borate residue since the polymerization reaction is simplified.

When the polymer compound of the present invention is polymerized by the Suzuki coupling reaction, the ratio of the total molar number of a bromine atom and an iodine atom as the above-described polymerization reactive group to the total molar number of a borate residue as the above-described polymerization reaction group is preferably 0.7 to 1.3, more preferably 0.8 to 1.2.

In the case of use of a palladium catalyst such as in the Stille coupling reaction and the like, the polymerization reactive group is preferably a halogen atom or an organotin residue substituted with three alkyl groups, and it is preferably a bromine atom, an iodine atom or an organotin residue substituted with three alkyl groups, since the polymerization reaction is simplified.

When the polymer compound of the present invention is polymerized by the Stille coupling reaction, the ratio of the total molar number of a bromine atom and an iodine atom as the above-described polymerization reactive group to the total molar number of an organotin residue substituted with three alkyl groups as the above-described polymerization reactive group is preferably 0.7 to 1.3, more preferably 0.8 to 1.2.

The organic solvent used in polymerization includes, for example, benzene, toluene, xylene, chlorobenzene, dichlorobenzene, tetrahydrofuran and dioxane. These organic solvents may be used each singly or two or more of them may be used in combination.

The base used in polymerization includes, for example, inorganic bases such as sodium carbonate, potassium carbonate, cesium carbonate, potassium fluoride, cesium fluoride, tripotassium phosphate and the like, and organic bases such as tetrabutylammonium fluoride, tetrabutylammonium chloride, tetrabutylammonium bromide, tetraethylammonium hydroxide, tetrabutylammonium hydroxide and the like.

The catalyst used in polymerization is preferably a catalyst composed of a transition metal complex such as a palladium complex such as tetrakis(triphenylphosphine)palladium, tris(dibenzylideneacetone)dipalladium, palladium acetate, dichlorobistriphenylphosphinepalladium and the like, and if necessary, a ligand such as triphenylphosphine, tri-tert-butylphosphine, tricyclohexylphosphine and the like. As these catalysts, those previously synthesized may be used, or those prepared in the reaction system may be used as they are. These catalysts may be used each singly or two or more of them may be used in combination.

The reaction temperature of polymerization is preferably 0 to 200°C, more preferably 0 to 150°C, further preferably 0 to 120°C.

The reaction time of polymerization is usually 1 hour or more, preferably 2 to 500 hours.

The post treatment of polymerization can be conducted by a known method, and there is, for example, a method in which the reaction liquid obtained in the above-described polymerization is added to a lower alcohol such as methanol and the like to cause deposition of a precipitate which is then filtrated and dried.

When the purity of the polymer compound of the present invention is low, it is preferable to purify the polymer compound by a method such as recrystallization, continuous extraction with a Soxhlet extractor, column chromatography and the like.

### <Production method of compound>

Next, the production method of a compound represented by the formula (1') will be illustrated. 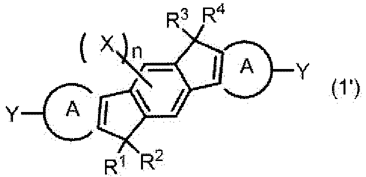 [wherein R¹, R², R³, R⁴, X, n and a ring A represent the same meaning as described above, two groups Y may be the same or different and represent a halogen atom, an organotin residue, a borate residue or boric acid.]

The compound represented by the formula (1') may be produced by any method, and for example, can be synthesized by a method as shown in a synthesis route (1) and a synthesis route (2).

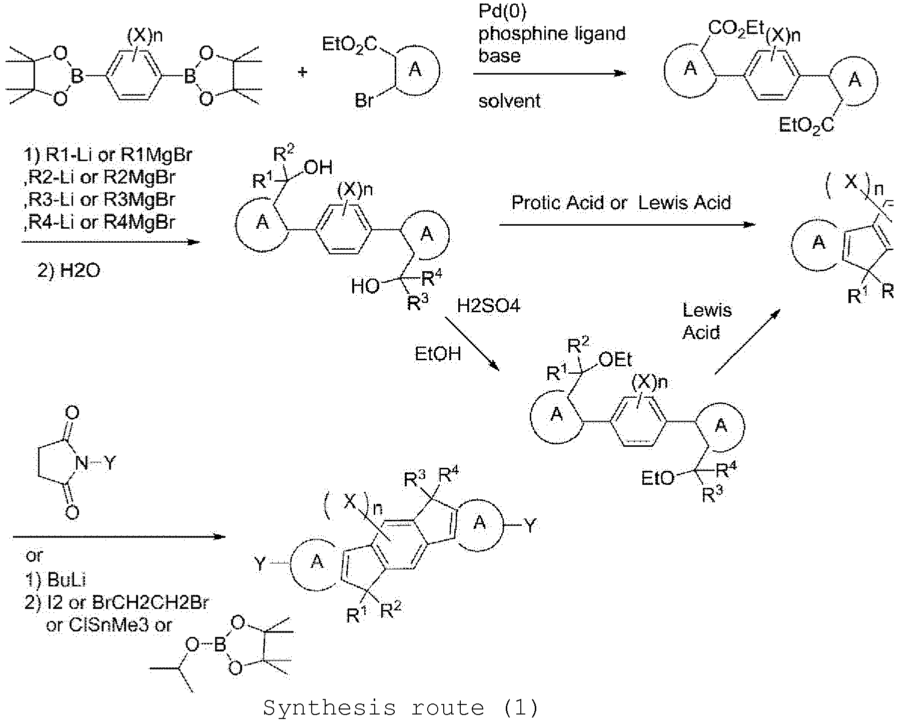

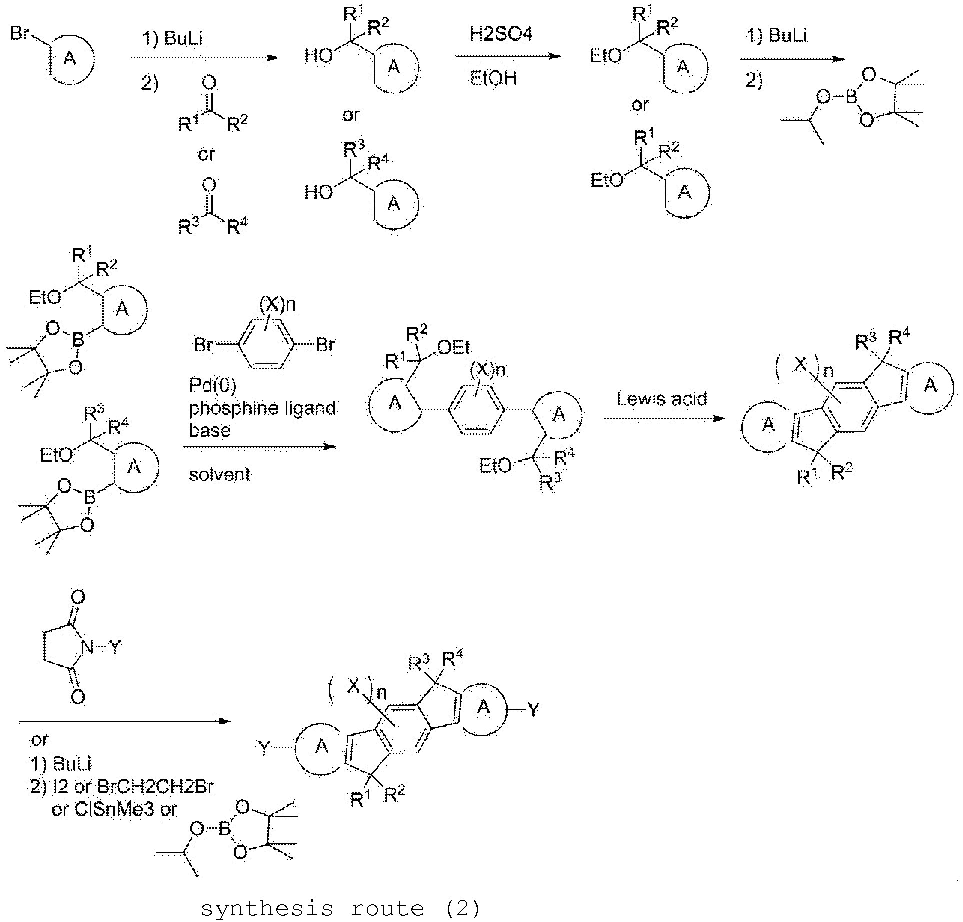

### <Organic film >

The organic film of the present invention may be one containing the polymer compound of the present invention singly or one containing two or more kinds of the polymer compounds of the present invention in combination. The organic film of the present invention may further contain a compound having carrier transportability (may be a low molecular weight compound or a polymer compound), in addition to the polymer compound of the present invention. When the organic film of the present invention contains a component other than the polymer compound of the present invention, the polymer compound of the present invention is contained in an amount of preferably 30 wt% or more, more preferably 50 wt% or more, further preferably 70 wt% or more.

The compound having carrier transportability includes low molecular weight compounds such as arylamine derivatives, stilbene derivatives, oligothiophene and derivatives thereof, oxadiazole derivatives, fullerenes and derivatives thereof, and the like; and, polyvinylcarbazole and derivatives thereof, polyaniline and derivatives thereof, polythiophene and derivatives thereof, polypyrrole and derivatives thereof, polyphenylenevinylene and derivatives thereof, polythienylenevinylene and derivatives thereof, polyfluorene and derivatives thereof, and the like.

The organic film may contain a polymer compound material other than the polymer compound of the present invention as a polymer binder for improving its property. The polymer binder is preferably one which does not excessively lower carrier transportability.

Examples of the polymer binder include poly(N-vinylcarbazole), polyaniline and derivatives thereof, polythiophene and derivatives thereof, poly(p-phenylenevinylene) and derivatives thereof, poly(2,5-thienylenevinylene) and derivatives thereof, polycarbonate, polyacrylate, polymethyl acrylate, polymethyl methacrylate, polystyrene, polyvinyl chloride and polysiloxane.

### <Organic semiconductor device>

The organic semiconductor device of the present invention is an organic semiconductor device comprising a first electrode, a second electrode and an organic film containing the polymer compound of the present invention (organic semiconductor layer). The organic semiconductor device of the present invention may further contain an electrode in addition to the first electrode and the second electrode. One embodiment of the organic semiconductor device of the present invention is an organic semiconductor device comprising a first electrode and a second electrode and comprising an organic semiconductor layer between the first electrode and the second electrode wherein the organic semiconductor layer contains the polymer compound of the present invention. When an organic film containing the polymer compound of the present invention is used in an organic semiconductor device, the polymer compound of the present invention can transport electrons and holes injected from an electrode or charges generated by light absorption, since the polymer compound of the present invention has high carrier mobility. The polymer compound of the present invention can be suitably used in various organic semiconductor devices such as a photoelectric conversion device, an organic transistor, an organic electroluminescent device, an organic field effect type transistor (OFET) sensor, an organic conductivity modulation type sensor and the like by utilizing such characteristics. These devices will be individually explained below.

### (Photoelectric conversion device)

A photoelectric conversion device containing the polymer compound of the present invention has one or more active layers containing the polymer compound of the present invention between a pair of electrodes at least one of which is transparent or semi-transparent.

A preferable form of a photoelectric conversion device containing the polymer compound of the present invention has a pair of electrodes at least one of which is transparent or semi-transparent, and an active layer formed from a composition of a p-type organic semiconductor and an n-type organic semiconductor. The polymer compound of the present invention is preferably used as a p-type organic semiconductor. The action mechanism of this form of photoelectric conversion device is explained. Incident light energy from a transparent or semi-transparent electrode is absorbed in an electron accepting compound (n-type organic semiconductor) such as a fullerene derivative and the like and/or an electron donating compound (p-type organic semiconductor) such as the compound of the present invention and the like, thereby generating an exciton composed of an electron and a hole bound mutually. When the generated exciton moves and reaches the heterojunction interface at which an electron accepting compound and an electron donating compound are adjacent, an electron and a hole separate due to a difference of respective HOMO energies and LUMO energies at the interface, to generate independently movable charges (electron and hole). The generated charges move to respective electrodes and can be taken out to the outside as an electric energy (electric current).

A photoelectric conversion device produced by using the polymer compound of the present invention is usually formed on a substrate. This substrate is advantageously one which does not chemically change in forming an electrode and forming a layer of an organic substance. The material of the substrate includes, for example, glass, plastic, polymer film and silicon. In the case of an opaque substrate, it is preferable that the opposite electrode (namely, an electrode far from the substrate) is transparent or semi-transparent.

Another form of a photoelectric conversion device comprising the polymer compound of the present invention is a photoelectric conversion device comprising a first active layer containing the polymer compound of the present invention and a second active layer containing an electron accepting compound such as a fullerene derivative and the like adjacent to the first active layer, between a pair of electrodes at least one of which is transparent or semi-transparent.

The above-described transparent or semi-transparent electrode material includes electrically conductive metal oxide films, semi-transparent metal films and the like. Specifically, use is made of films fabricated by using an electrically conductive material composed of indium oxide, zinc oxide, tin oxide, and composites thereof: indium•tin•oxide (hereinafter, referred to as "ITO" in some cases), indium•zinc•oxide and the like, NESA and, gold, platinum, silver, copper and the like, and preferable are ITO, indium•zinc•oxide and tin oxide. The electrode fabrication method includes a vacuum vapor deposition method, a sputtering method, an ion plating method, a plating method and the like. As the electrode material, an organic transparent conductive film composed of polyaniline and derivatives thereof, polythiophene and derivatives thereof and the like may be used.

One electrode may not be transparent, and metals, conductive polymers and the like can be used as the electrode material of the electrode. Specific examples of the electrode material include metals such as lithium, sodium, potassium, rubidium, cesium, magnesium, calcium, strontium, barium, aluminum, scandium, vanadium, zinc, yttrium, indium, cerium, samarium, europium, terbium, ytterbium and the like, and alloys composed of two or more of them, or alloys composed of one or more of the above-described metals and one or more metals selected from the group consisting of gold, silver, platinum, copper, manganese, titanium, cobalt, nickel, tungsten and tin, graphite, graphite intercalation compounds, polyaniline and derivatives thereof and polythiophene and derivatives thereof. The alloy includes a magnesium-silver alloy, a magnesium-indium alloy, a magnesium-aluminum alloy, an indium-silver alloy, a lithium-aluminum alloy, a lithium-magnesium alloy, a lithium-indium alloy, a calcium-aluminum alloy and the like.

As a means for improving photoelectric conversion efficiency, an additional intermediate layer other than the active layer may be used. The material used as the intermediate layer includes halides of alkali metals and alkaline earth metals such as lithium fluoride and the like, oxides such as titanium oxide and the like, PEDOT (poly-3,4-ethylenedioxythiophene) and the like.

The active layer may contain the polymer compound of the present invention singly or two or more of the polymer compounds of the present invention in combination. A compound other than the polymer compound of the present invention can also be mixed and used as an electron donating compound and/or an electron accepting compound in the active layer. The electron donating compound and the electron accepting compound are determined relatively based on the energy levels of these compounds.

The above-described electron donating compound includes, for example, pyrazoline derivatives, arylamine derivatives, stilbene derivatives, triphenyldiamine derivatives, oligothiophene and derivatives thereof, polyvinylcarbazole and derivatives thereof, polysilane and derivatives thereof, polysiloxane derivatives having an aromatic amine residue in the side chain or the main chain, polyaniline and derivatives thereof, polythiophene and derivatives thereof, polypyrrole and derivatives thereof, polyphenylenevinylene and derivatives thereof and polythienylenevinylene and derivatives thereof, in addition to the polymer compound of the present invention.

The above-described electron accepting compound includes, for example, carbon materials, metal oxides such as titanium oxide and the like, oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, polyfluorene and derivatives thereof, phenanthrene derivatives such as 2,9-dimethyl-4,7-diphenyl-1,10-phenanthroline (Bathocuproine) and the like, fullerenes and fullerene derivatives, in addition to the polymer compound of the present invention, and titanium oxide, carbon nanotubes, fullerenes and fullerene derivatives are preferable, fullerenes and fullerene derivatives are particularly preferable.

The fullerenes and fullerene derivatives include C₆₀, C₇₀, C₇₆, C₇₈, C₈₄ and derivatives thereof. The specific structure of the fullerene derivative includes those as shown below.

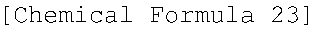

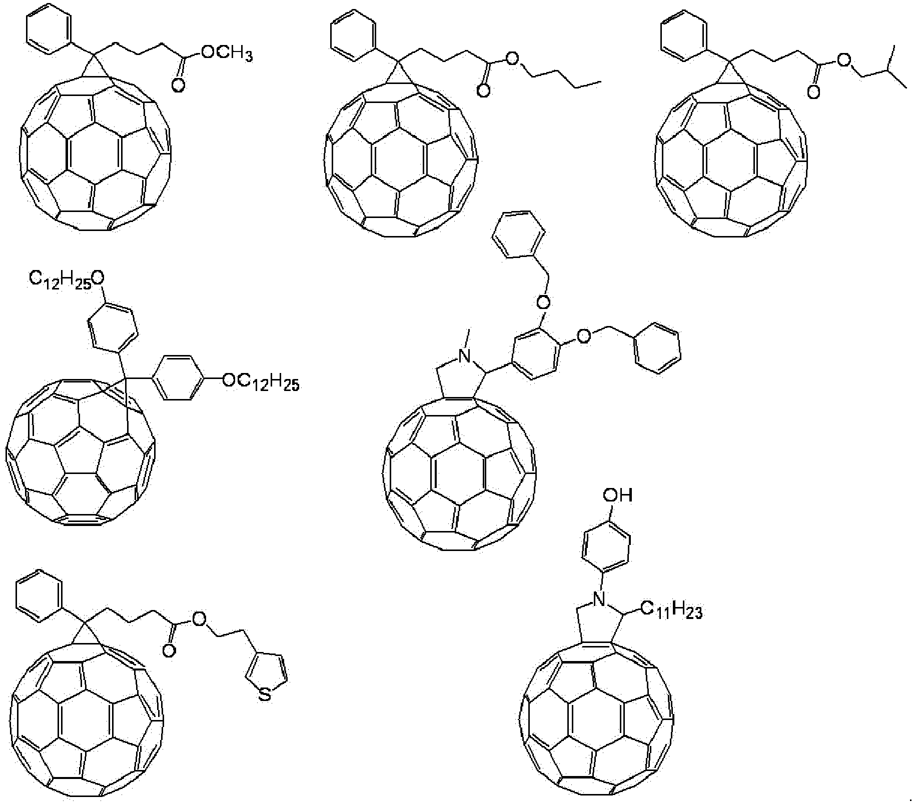

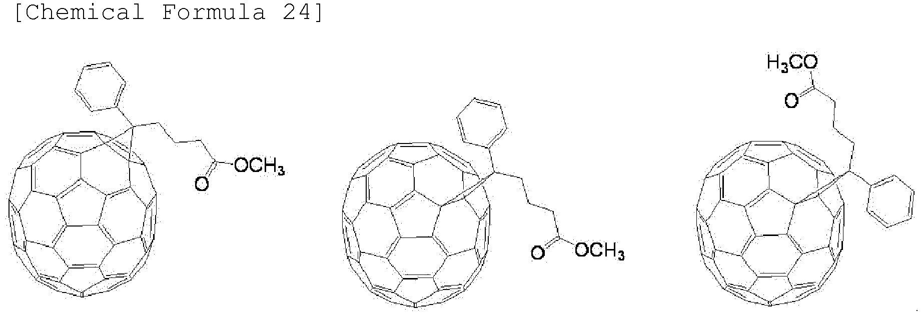

Examples of the fullerene derivative include [6,6]phenyl-C61 butyric acid methyl ester (C60PCBM, [6,6]-Phenyl C61 butyric acid methyl ester), [6,6]phenyl-C70 butyric acid methyl ester (C70PCBM, [6,6]-Phenyl C70 butyric acid methyl ester), [6,6]phenyl-C84 butyric acid methyl ester (C84PCBM, [6,6]-Phenyl C84 butyric acid methyl ester), [6,6]thienyl-C60 butyric acid methyl ester ([6,6]-Thienyl C60 butyric acid methyl ester) and the like.

When the polymer compound of the present invention and a fullerene derivative are contained in the active layer, the proportion of the fullerene derivative is preferably 10 to 1000 parts by weight, more preferably 20 to 500 parts by weight with respect to 100 parts by weight the polymer compound of the present invention.

The thickness of the active layer is usually preferably 1 nm to 100 µm, more preferably 2 nm to 1000 nm, further preferably 5 nm to 500 nm, still more preferably 20 nm to 200 nm.

The active layer may be produced by any method and the production method includes, for example, film formation from a solution containing the polymer compound of the present invention and film formation by a vacuum vapor deposition method.

A preferable method of producing a photoelectric conversion device is a production method of a photoelectric conversion device comprising a first electrode and a second electrode and comprising an active layer between the first electrode and the second electrode, comprising a step of applying a solution (ink) containing the polymer compound of the present invention and a solvent by an application method on the first electrode to form an active layer and a step of forming a second electrode on the active layer.

The solvent used for film formation from a solution is advantageously one which dissolves the polymer compound of the present invention. The solvent includes, for example, unsaturated hydrocarbon solvents such as toluene, xylene, mesitylene, tetralin, decalin, bicyclohexyl, n-butylbenzene, sec-butylbenzene, tert-butylbenzene and the like, halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane, bromocyclohexane and the like, halogenated unsaturated hydrocarbon solvents such as chlorobenzene, dichlorobenzene, trichlorobenzene and the like, and ether solvents such as tetrahydrofuran, tetrahydropyran and the like. The polymer compound of the present invention can be dissolved usually in an amount of 0.1 wt% or more in the above-described solvent.

In the case of film formation using a solvent, application methods such as a slit coat method, a knife coat method, a spin coat method, a casting method, a micro gravure coat method, a gravure coat method, a bar coat method, a roll coat method, a wire bar coat method, a dip coat method, a spray coat method, a screen printing method, a gravure printing method, a flexo printing method, an offset printing method, an inkjet printing method, a dispenser printing method, a nozzle coat method, a capillary coat method and the like can be used, and preferable are a slit coat method, a capillary coat method, a gravure coat method, a micro gravure coat method, a bar coat method, a knife coat method, a nozzle coat method, an inkjet printing method and a spin coat method.

From the standpoint of film formability, the surface tension of a solvent at 25°C is preferably larger than 15 mN/m, more preferably larger than 15 mN/m and smaller than 100 mN/m, further preferably larger than 25 mN/m and smaller than 60 mN/m.

### (Organic film solar battery)

In a photoelectric conversion device using the polymer compound of the present invention, when light such as solar light and the like is applied from a transparent or semi-transparent electrode, photovoltaic power is generated between electrodes, thus, the photoelectric conversion device can be operated as an organic film solar battery. By integrating a plurality of organic film solar batteries, they can also be used as an organic film solar battery module.

By applying light from a transparent or semi-transparent electrode under condition of application of voltage between electrodes or no application of voltage, photocurrent flows, thus the photoelectric conversion device can be operated as an organic optical sensor. By integrating a plurality of organic optical sensors, they can also be used as an organic image sensor.

The organic film solar battery can take basically the same module structure as that of a conventional solar battery module. A solar battery module generally takes a structure in which a cell is constituted on a supporting substrate made of a metal, ceramic or the like, its upper side is covered with a filling resin, protective glass or the like and light is incorporated from the opposite side of the supporting substrate, however, it is also possible to provide a structure in which a transparent material such as reinforced glass and the like is used as a supporting substrate, a cell is constituted on this and light is incorporated from the side of the transparent supporting substrate. Specifically, module structures called super straight type, sub straight type or potting type, substrate integrated module structures used in amorphous silicon solar batteries, and the like, are known. Also an organic film solar battery produced by using the polymer compound of the present invention can appropriately adopt these module structures depending on the use object, the use place and environments.

A typical super straight type or sub straight type module has a structure in which cells are placed at regular intervals between supporting substrates one or both of which are transparent and having undergone an antireflection treatment, mutually adjacent cells are connected via a metal lead, flexible wiring or the like, a collecting electrode is placed at the exterior edge, and generated electric power is taken out to the outside. Between a substrate and a cell, various kinds of plastic materials such as ethylene vinyl acetate (EVA) and the like depending on the object may be used in the form of a film or a filling resin, for protection of the cell and improvement of power collecting efficiency. In the case of use at a place where the surface is not required to be covered with a hard material such as a place receiving little impact from the outside, it is possible that the surface protective layer is constituted of a transparent plastic film or the above-described filling resin is hardened to impart a protective function, and a supporting substrate on one side is deleted. The circumference of the supporting substrate is fixed in the form of sandwich by a metal frame and the aperture between the supporting substrate and the frame is sealed with a sealing material, for ensuring internal sealing and module stiffness. When a flexible material is used as a cell itself or a supporting substrate, a filling material and a sealing material, it is also possible to constitute a solar battery on a curved surface.

In the case of a solar battery using a flexible supporting body such as a polymer film and the like, it is possible that cells are formed in series while feeding a supporting body in the form of a roll, cut into desired size, then, the periphery is sealed with a flexible and moisture-proof material, thus, a battery body is fabricated. Also, a module structure called "SCAF" described in Solar Energy Materials and Solar Cells, 48, pp. 383-391 can be adopted. Further, a solar battery using a flexible supporting body can also be adhered and fixed to curved glass or the like and used.

Fig. 1 is a schematic cross-sectional view of a photoelectric conversion device of the present invention. A photoelectric conversion device 300 has a substrate 1, a first electrode 7a formed on the substrate 1, an active layer 2 formed on the first electrode 7a, and a second electrode 7b formed on the active layer 2.

### (Organic electroluminescent device)

The polymer compound of the present invention can also be used in an organic electroluminescent device (hereinafter, referred to as "organic EL device" in some cases). The organic EL device has a light emitting layer between a pair of electrodes at least one of which is transparent or semi-transparent. The organic EL device may contain a hole transporting layer and an electron transporting layer in addition to the light emitting layer. The polymer compound of the present invention is contained in any of the light emitting layer, the hole transporting layer and the electron transporting layer. Charge transporting materials (denoting a generic term of an electron transporting material and a hole transporting material) may be contained, in addition to the polymer compound of the present invention, in the light emitting layer. The organic EL device includes a device comprising an anode, a light emitting layer and a cathode, a device comprising an anode, a light emitting layer, an electron transporting layer and a cathode and further comprising an electron transporting layer containing an electron transporting material between the cathode and the light emitting layer and adjacent to the light emitting layer, a device comprising an anode, a hole transporting layer, a light emitting layer and a cathode and further comprising a hole transporting layer containing a hole transporting material between the anode and the light emitting layer and adjacent to the light emitting layer, a device comprising an anode, a hole transporting layer, a light emitting layer, an electron transporting layer and a cathode, and the like.

### (Organic transistor)

The organic transistor includes those having a constitution comprising a source electrode and a drain electrode, an active layer working as a current pathway between these electrodes and containing the polymer compound of the present invention, and a gate electrode controlling the amount of current passing through the current pathway. The organic transistor having such a constitution includes an organic field effect type transistor, an organic electrostatic induction type transistor and the like.

The organic field effect type transistor is usually an organic transistor comprising a source electrode and a drain electrode, an active layer working as a current pathway between these electrodes and containing the polymer compound of the present invention, a gate electrode controlling the amount of current passing through the current pathway, and an insulating layer disposed between the active layer and the gate electrode. Particularly, preferable is an organic transistor in which a source electrode and a drain electrode are provided in contact with an active layer and further, a gate electrode is provided sandwiching an insulating layer in contact with an active layer.

The organic electrostatic induction type transistor is usually an organic transistor comprising a source electrode and a drain electrode, an active layer working as a current pathway between these electrodes and containing the polymer compound of the present invention, and a gate electrode controlling the amount of current passing through the current pathway wherein the gate electrode is provided in the active layer. Particularly, preferable is an organic transistor in which a source electrode, a drain electrode and the above-described gate electrode are provided in contact with the above-described active layer.

The gate electrode advantageously has a structure by which a current pathway flowing from a source electrode to a drain electrode can be formed and the amount of current passing through the current pathway can be controlled by the voltage applied to the gate electrode, and is, for example, a comb-shaped electrode.

The organic film transistor of the present invention can be suitably used in an organic electroluminescent device, an electronic tag and a liquid crystal display device.

The composition or polymer compound of the present invention can also be used for production of an OFET sensor. The OFET sensor of the present invention uses an organic field effect type transistor as a signal conversion device outputting an input signal as an electric signal in which any structure of a metal, an insulating film and an organic semiconductor layer is endowed with a sensitive function or a selective function. The OFET sensor of the present invention includes, for example, a bio sensor, a gas sensor, an ion sensor and a humidity sensor.

The bio sensor has a substrate and an organic film transistor provided on the substrate. The organic film transistor has an organic semiconductor layer, a source region and a drain region provided in contact with an organic semiconductor, a channel region in the organic semiconductor layer provided between the source region and the drain region, a gate electrode which can apply electric field on the channel region, and a gate insulating film provided between the channel region and the gate electrode. The organic film transistor has a probe (sensitive region) mutually acting specifically with a standard substance in the channel region and/or the gate insulating film, and when the concentration of the standard substance changes, a characteristic change of the probe occurs, thus, the present transistor functions as a bio sensor.

The means for detecting a standard substance in a test sample includes, for example, a bio sensor in which a biological molecule such as a nucleic acid, a protein and the like or an artificially synthesized functional group is fixed as a probe to the surface of a solid phase carrier.

In this method, a standard substance is captured to the surface of a solid phase carrier by utilizing specific affinity of a biological molecule such as a mutual action of complementary nucleic acid chains, a mutual action of an antigen-antibody reaction, a mutual action of an enzyme-substrate reaction, a mutual action of receptor-ligand, and the like. Therefore, a substance showing specific affinity to a standard substance is selected as a probe.

The probe is fixed to the surface of a solid phase carrier by a method according to the kind of the probe and the kind of the solid phase carrier. It is also possible to synthesize a probe on the surface of a solid phase carrier (for example, a method of synthesizing a probe by a nucleic acid elongation reaction). In any case, a solid phase carrier surface to which a probe has been fixed and a test sample are mutually brought into contact and cultured under suitable conditions, resultantly, a probe-standard substance complex is formed on the solid phase carrier surface. A channel region and/or a gate insulating film itself contained in an organic film transistor may function as a probe.

The gas sensor has a substrate and an organic film transistor provided on the substrate. The organic film transistor has an organic semiconductor layer, a source region and a drain region provided in contact with an organic semiconductor, a channel region in the semiconductor layer provided between the source region and the drain region, a gate electrode which can apply electric field on the channel region, and a gate insulating film provided between the channel region and the gate electrode. In the organic film transistor, the channel region and/or the gate insulating film functions as a gas sensitive part. When a detection gas is adsorbed to or released from a gas sensitive part, a change of characteristics (electric conductivity, permittivity and the like) of the gas sensitive part occurs, thus, the present transistor functions as a gas sensor.

The gas to be detected includes, for example, an electron accepting gas and an electron donating gas. The electron accepting gas includes, for example, a halogen gas such as F₂, Cl₂ and the like; a nitrogen oxide gas; a sulfur oxide gas; and a gas of an organic acid such as acetic acid and the like. The electron donating gas includes, for example, an ammonia gas; a gas of amines such as aniline and the like; a carbon monoxide gas; and a hydrogen gas.

The composition or polymer compound of the present invention can also be used for production of a pressure sensor. The pressure sensor of the present invention has a substrate and an organic film transistor provided on the substrate. The organic film transistor has an organic semiconductor layer, a source region and a drain region provided in contact with an organic semiconductor, a channel region in the organic semiconductor layer provided between the source region and the drain region, a gate electrode which can apply electric field on the channel region, and a gate insulating film provided between the channel region and the gate electrode. In the organic film transistor, the channel region and/or the gate insulating film functions as a pressure sensitive part. When the pressure sensitive part senses pressure, a characteristic change of the pressure sensitive part occurs, thus, the present transistor functions as a pressure sensitive sensor.

When the gate insulating film functions as a pressure sensitive part, it is preferable that the gate insulating film contains an organic material since an organic material is excellent in flexibility and stretchability as compared with an inorganic material.

When the channel region functions as a pressure sensitive part, the organic film transistor may further have an orientation layer, for further enhancing crystallinity of an organic semiconductor contained in the channel region. The orientation layer includes, for example, a monomolecular film formed on a gate insulating film by using a silane coupling agent such as hexamethyldisilazane and the like.

Further, the composition or polymer compound of the present invention can also be used for production of a conductivity modulation type sensor. The conductivity modulation type sensor of the present invention uses a conductivity measuring device as a signal conversion device outputting an input signal as an electric signal, and it is a film containing the composition or polymer compound of the present invention or one obtained by imparting a sensitive function or a selective function against input of the sensor target to a coating of a film containing the composition or polymer compound of the present invention. The conductivity modulation type sensor of the present invention detects input of the sensor target as a change of conductivity of the composition or polymer compound of the present invention. The conductivity modulation type sensor of the present invention includes, for example, a bio sensor, a gas sensor, an ion sensor and a humidity sensor.

Still further, the composition or polymer compound of the present invention can also be used for production of an amplifying circuit containing an organic field effect type transistor as an amplifying circuit for amplifying an output signal from various sensors such as a bio sensor, a gas sensor, an ion sensor, a humidity sensor, a pressure sensor and the like formed separately.

Moreover, the composition or polymer compound of the present invention can also be used for production of a sensor array containing a plurality of various sensors such as a bio sensor, a gas sensor, an ion sensor, a humidity sensor, a pressure sensor and the like.

Still moreover, the composition or polymer compound of the present invention can also be used for production of an amplifying circuit-equipped sensor array containing a plurality of various sensors such as a bio sensor, a gas sensor, an ion sensor, a humidity sensor, a pressure sensor and the like formed separately and having an organic field effect type transistor as an amplifying circuit for separately amplifying output signals from various sensors.

### EXAMPLES

Examples are shown below for illustrating the present invention further in detail, but the present invention is not limited to them.

### (NMR analysis)

A compound was dissolved in deuterated chloroform, and its NMR was measured using an NMR apparatus (manufactured by Varian Inc., INOVA300).

### (Molecular weight analysis)

The number-average molecular weight and the weight-average molecular weight of a polymer compound were determined by using gel permeation chromatography (GPC, manufactured by Waters Corporation, trade name: Alliance GPC 2000). The polymer compound to be measured was dissolved in orthodichlorobenzene, and the solution was injected into GPC.

Orthodichlorobenzene was used as the mobile phase of GPC. TSKgel GMHHR-H(S)HT (two columns are connected, manufactured by Tosoh Corp.) was used as the column. An UV detector was used as the detector.

### Synthesis Example 1

### (Synthesis of compound 2)

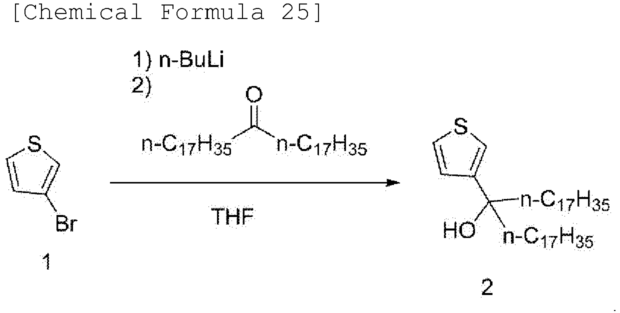

A nitrogen gas atmosphere was prepared in a reaction vessel, then, a compound 1 (28.5 g, 175 mmol) and dehydrated diethyl ether (500 mL) were added, and a uniform solution was prepared. While keeping the resultant solution at -70°C, a 1.60 M n-butyllithium hexane solution (120 mL, 192 mmol) was dropped over a period of 20 minutes. Thereafter, the mixture was stirred at -70°C for 5 hours. Thereafter, to this was added 18-penatriacontanone (62 g, 122 mmol), and the mixture was stirred at -70°C for 10 minutes, then, gently heated up to room temperature (23°C) and stirred for 5 hours. Thereafter, to this was added water (500 mL) to stop the reaction, and a 10 wt% acetic acid aqueous solution was added to make the reaction solution acidic. Thereafter, the reaction product was extracted using hexane. The resultant organic layer was washed with water, dried over anhydrous magnesium sulfate, and filtrated. The resultant filtrate was concentrated by an evaporator, then, the solvent was distilled off, to obtain 70.9 g of a compound 2. The yield was 98%.
¹H-NMR (300 MHz, CDCl₃) : δ (ppm) = 7.266 (d, 1H), 6.960 (d, 1H), 1.746 (m, 4H), 1.253 (m, 60H), 0.879 (t, 6H).

### Synthesis Example 2

### (Synthesis of compound 3)

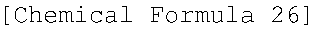

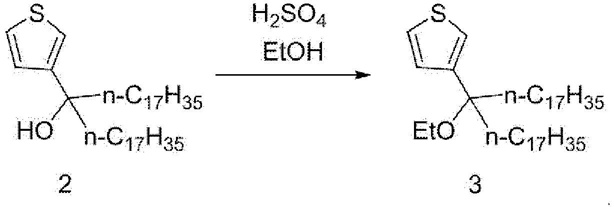

A nitrogen gas atmosphere was prepared in a reaction vessel, then, the compound 2 (70.9 g, 120 mmol), dehydrated ethanol (400 mL) and hexane (200 mL) were added, and further, 96 wt% concentrated sulfuric acid (6.1 mL, 120 mmol) was added, then, the mixture was stirred at room temperature for 3 hours. Thereafter, to this was added water (300 mL) to stop the reaction, and the resultant organic layer was further washed with water, dried over anhydrous magnesium sulfate, and filtrated. The resultant filtrate was concentrated by an evaporator, then, the solvent was distilled off. The resultant residue was purified by silica gel column chromatography using hexane as the mobile phase, to obtain 62 g of a compound 3. The yield was 83.3%.
¹H-NMR (300 MHz, CDCl₃) : δ (ppm) = 7.24 (d, 1H), 7.05 (m, 2H), 3.15 (q, 2H), 1.82-1.73 (m, 4H), 1.55-1.21 (m, 60H), 1.13 (t, 3H), 0.88 (t, 6H).

### Synthesis Example 3

### (Synthesis of compound 4)

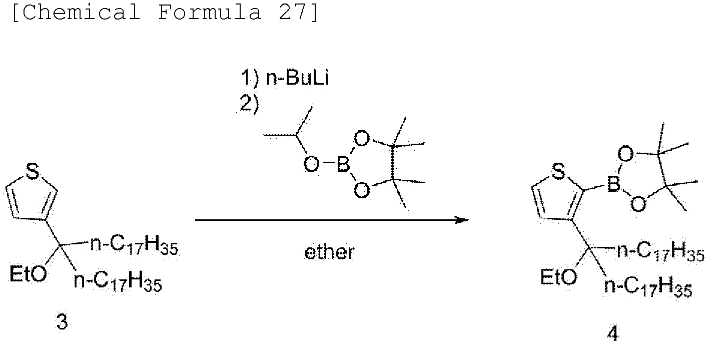

A nitrogen gas atmosphere was prepared in a reaction vessel, then, the compound 3 (61.9 g, 100 mmol) and dehydrated diethyl ether (600 mL) were added, and a uniform solution was prepared. While keeping the resultant solution at -70°C, a 1.6 M n-butyllithium hexane solution (81.3 mL, 130 mmol) was dropped over a period of 20 minutes. Thereafter, the mixture was stirred at -70°C for 10 minutes, then, gently heated up to room temperature (23°C) and stirred for 1.5 hours. Thereafter, while keeping the resultant solution at -70°C, 2-isopropoxy-4,4,5,5-tetramethyl-1,3,2-dioxaborolane (37.2 g, 130 mmol) was added. Thereafter, the mixture was stirred at -70°C for 10 minutes, then, stirred at room temperature (25°C) for 2 hours. Thereafter, to this was added water (300 mL) to stop the reaction, and the organic layer was extracted. The resultant organic layer was washed with water, dried over anhydrous magnesium sulfate, and filtrated. The resultant filtrate was concentrated by an evaporator, then, the solvent was distilled off, to obtain 75 g of an oil containing a compound 4. The yield was 100%.
¹H-NMR (300 MHz, CDCl₃) : δ (ppm) = 7.42 (d, 1H), 7.26 (d, 1H), 3.23 (q, 2H), 2.05-1.91 (m, 4H), 1.33 (s, 12H), 1.25-0.96 (m, 63H), 0.88 (s, 6H).

### Synthesis Example 4

### (Synthesis of compound 6)

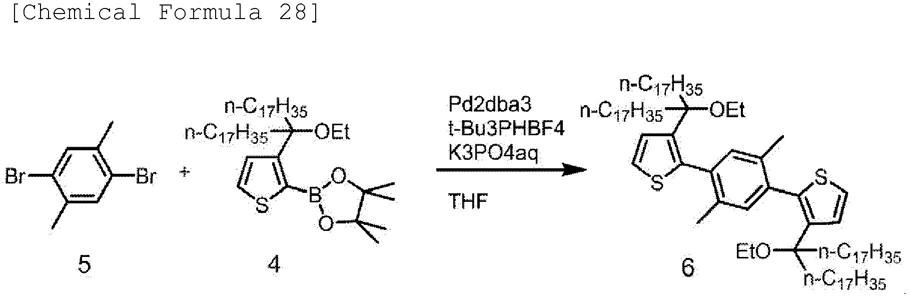

A nitrogen gas atmosphere was prepared in a reaction vessel equipped with a reflux tube, then, a compound 5 (5.3 g, 20 mmol) and dry THF (260 mL) were added, and the mixture was deaerated for 5 minutes by bubbling with argon. Thereafter, to this were added tris(dibenzylideneacetone)dipalladium(0) (916 mg, 1.0 mmol), tri-tert-butylphosphonium tetrafluoroborate (1160 mg, 4.0 mmol) and a 3 M potassium phosphate aqueous solution (100 mL, 0.3 mol), and the mixture was heated at 90°C. Thereafter, a dry THF (40 mL) solution of the compound 4 (37.3 g, 50 mmol) deaerated for 5 minutes by bubbling with argon was dropped into this at 90°C over a period of 5 minutes, and the mixture was stirred at the same temperature for 4.5 hours. Thereafter, the reaction product was extracted using hexane (200 mL). The resultant organic layer was washed with saturated saline, dried over anhydrous magnesium sulfate, and filtrated. The resultant filtrate was concentrated by an evaporator, then, the solvent was distilled off. The resultant residue was purified by silica gel column chromatography using a mixed solvent of hexane and chloroform as a moving bed, to obtain 16.1 g of a compound 6. The yield was 60.1%.
¹H-NMR (300 MHz, CDCl₃) : δ (ppm) = 7.22 (d, 2H), 7.18-7.08 (m, 2H), 7.05 (s, 2H), 3.28-3.12 (m, 4H), 2.14 (s, 6H), 1.55-0.98 (m, 134H), 0.92-0.84 (m, 12H).

### Synthesis Example 5

### (Synthesis of compound 7)

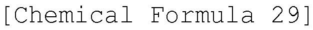

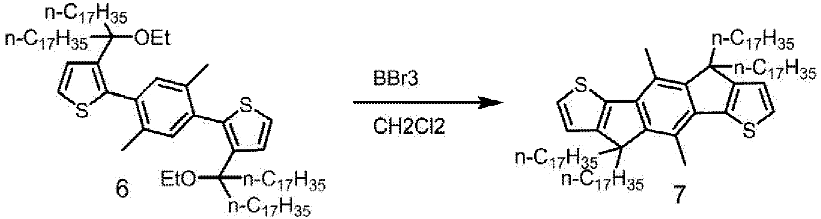

A nitrogen gas atmosphere was prepared in a reaction vessel, then, the compound 6 (16.1 g, 12.0 mmol) and dry methylene chloride (240 mL) were added. Thereafter, to this was added a 1 M boron tribromide methylene chloride solution (48 mL, 48 mmol) at -50°C, and the mixture was gently heated up to room temperature (23°C) and stirred for 4 hours. Thereafter, the reaction liquid was added to water to stop the reaction, then, the reaction product was extracted using chloroform. The resultant organic layer was washed with water, dried over anhydrous magnesium sulfate, and filtrated. The resultant filtrate was concentrated by an evaporator, then, the solvent was distilled off. The resultant residue was purified by recrystallizing from hexane, to obtain 7.72 g of a compound 7. The yield was 51.5%.
¹H-NMR (300 MHz, CDCl₃) : δ (ppm) = 7.28 (d, 2H), 6.96 (d, 2H), 2.57 (s, 6H), 2.22-2.12 (m, 4H), 2.07-1.92 (m, 4H), 1.36-0.72 (m, 116H).

### Synthesis Example 6

### (Synthesis of compound 8)

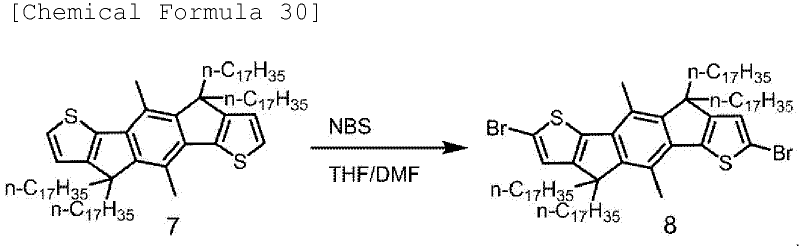

A nitrogen gas atmosphere was prepared in a reaction vessel, then, the compound 7 (2.66 g, 2.18 mmol), THF (200 mL) and DMF (100 mL) were added. Thereafter, to this was added N-bromosuccinic imide (2.35 g, 13.2 mmol) at room temperature, and the mixture was stirred at room temperature for 3 hours. Thereafter, to this were added a saturated sodium thiosulfate aqueous solution (5 mL) and water (100 mL), and the mixture was stirred for 5 minutes, then, filtrated. The resultant powder was washed with water, subsequently with acetone, and recrystallized using hexane, to obtain 6.5 g of a compound 8. The yield was 77.1%.
¹H-NMR (300 MHz, CDCl₃) : δ (ppm) = 6.94 (s, 2H), 3.91 (2, 6H), 2.19-2.08 (m, 4H), 2.03-1.92 (m, 4H), 1.35-0.70 (m, 116H).

### Example 1

### (Synthesis of polymer compound A)

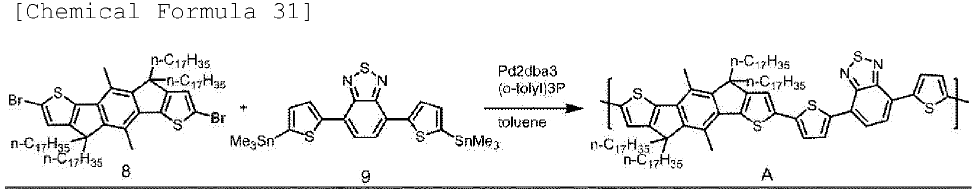

A nitrogen gas atmosphere was prepared in a reaction vessel equipped with a reflux tube, then, the compound 8 (210.9 mg, 0.15 mmol), a compound 9 (93.9 mg, 0.15 mmol) and dry toluene (15 mL) were added, and the mixture was deaerated for 10 minutes by bubbling with an argon gas. Thereafter, to this were added tris(dibenzylideneacetone)dipalladium(0) (6.9 mg, 7.5 µmol) and tri(o-tolyl)phosphine (9.1 mg, 30 µmol). The resultant reaction solution was heated up to 100°C, then, stirred for 3 hours. The reaction liquid was cooled down to room temperature, and purified by a silica gel column, then, the resultant toluene solution was poured into methanol, to obtain a solid. The resultant solid was filtrated, washed in a Soxhlet extractor using acetone as a solvent, and dried, to obtain a polymer compound A. The amount gained was 206.1 mg, and the polystyrene-equivalent number-average molecular weight thereof was 4.4×10⁴ and the weight-average molecular weight thereof was 8.2×10⁴.

### Synthesis Example 7

### (Synthesis of compound 11)

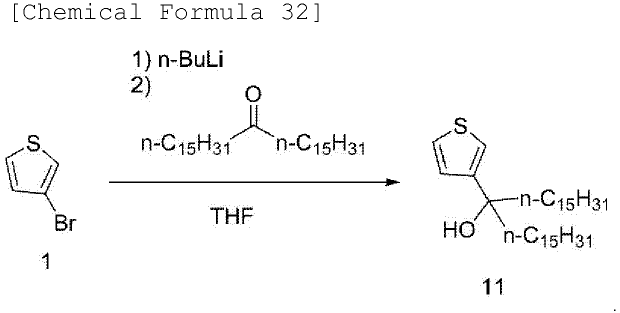

A nitrogen gas atmosphere was prepared in a reaction vessel, then, the compound 1 (16.0 g, 98.1 mmol) and dehydrated diethyl ether (280 mL) were added, and a uniform solution was prepared. While keeping the resultant solution at -68°C, a 1.65 M n-butyllithium hexane solution (65.4 mL, 0.108 mol) was dropped over a period of 10 minutes. Thereafter, the mixture was stirred at -68°C for 5 hours. Thereafter, to this was added 16-hentriacontanone (48.7 g, 0.108 mol), and the mixture was stirred at -78°C for 10 minutes, then, stirred at room temperature (25°C) for 5 hours. Thereafter, to this was added water (200 mL) to stop the reaction, and a 10 wt% acetic acid aqueous solution was added to make the reaction solution acidic. Thereafter, the reaction product was extracted using hexane. The resultant organic layer was washed with water, dried over anhydrous magnesium sulfate, and filtrated. The resultant filtrate was concentrated by an evaporator, then, the solvent was distilled off, to obtain 70 g of a compound 11. The yield was 100%.
¹H-NMR (300 MHz, CDCl₃) : δ (ppm) = 0.879 (t, 6H), 1.253 (m, 52H), 1.746 (m, 4H), 6.960 (d, 1H), 7.266 (d, 1H).

### Synthesis Example 8

### (Synthesis of compound 12)

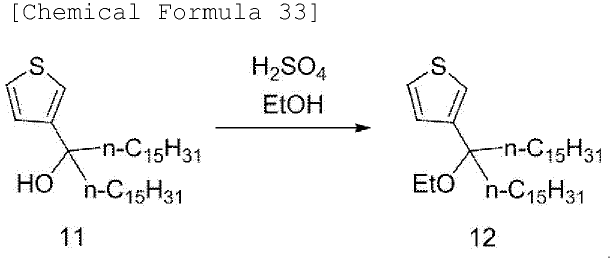

A nitrogen gas atmosphere was prepared in a reaction vessel, then, the compound 11 (53 g, 98 mmol) and dehydrated ethanol (500 mL) were added, and a suspension was prepared. To the resultant suspension was added 96 wt% concentrated sulfuric acid (3.0 mL, 56 mmol), then, the mixture was stirred at room temperature for 3 hours. Thereafter, to this was added water (200 mL) to stop the reaction, and the reaction product was extracted using hexane. The resultant organic layer was washed with water, dried over anhydrous magnesium sulfate, and filtrated. The resultant filtrate was concentrated by an evaporator, then, the solvent was distilled off. The resultant residue was purified by silica gel column chromatography using hexane as a moving bed, to obtain 20.7 g of a compound 12. The yield was 37%.
¹H-NMR (300 MHz, CDCl₃) : δ (ppm) = 0.88 (t, 6H), 1.13 (t, 3H), 1.24 (m, 52H), 1.77 (m, 4H), 3.15 (q, 2H), 7.05 (m, 2H), 7.24 (d, 1H).

### Synthesis Example 9

### (Synthesis of compound 13)

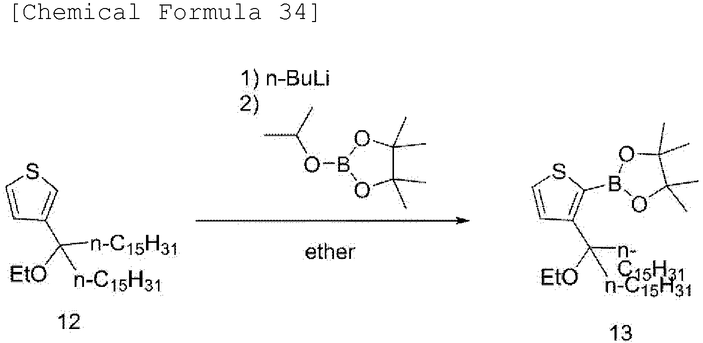

A nitrogen gas atmosphere was prepared in a reaction vessel, then, the compound 12 (2.0 g, 3.6 mmol) and dehydrated diethyl ether (35 mL) were added, and a uniform solution was prepared. While keeping the resultant solution at -68°C, a 1.65 M n-butyllithium hexane solution (2.3 mL, 3.7 mol) was dropped over a period of 10 minutes. Thereafter, the mixture was stirred at -68°C for 10 minutes, then, stirred at room temperature (25°C) for 1.5 hours. Thereafter, while keeping the resultant solution at -68°C, 2-isopropoxy-4,4,5,5-tetramethyl-1,3,2-dioxaborolane (0.69 g, 3.7 mmol) was added. Thereafter, the mixture was stirred at -68°C for 10 minutes, then, stirred at room temperature (25°C) for 2 hours. Thereafter, to this was added water (100 mL) to stop the reaction, and the reaction product was extracted using diethyl ether. The resultant organic layer was washed with water, dried over anhydrous magnesium sulfate, and filtrated. The resultant filtrate was concentrated by an evaporator, then, the solvent was distilled off, to obtain 2.45 g of a compound 13. The yield was 100%.
¹H-NMR (300 MHz, CDCl₃) : δ (ppm) = 1.335 (s, 12H), 1.989 (m, 4H), 3.224 (q, 2H), 7.264 (d, 1H), 7.422 (d, 1H).

### Synthesis Example 10

### (Synthesis of compound 15)

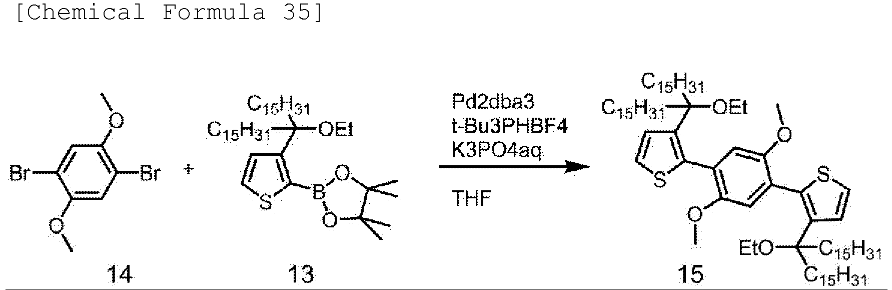

A nitrogen gas atmosphere was prepared in a reaction vessel equipped with a reflux tube, then, 1,4-dibromo-2,5-dimethoxybenzene (1.13 g, 3.8 mmol) and dry THF (260 mL) were added, and the mixture was deaerated for 10 minutes by bubbling with argon. Thereafter, to this were added tris(dibenzylideneacetone)dipalladium(0) (170 mg, 0.19 mmol), tri-tert-butylphosphonium tetrafluoroborate (230 mg, 0.76 mmol) and a 3M potassium phosphate aqueous solution (19.1 mL, 52.3 mmol), and the mixture was heated at 80°C. Thereafter, a dry THF (115 mL) solution of the compound 13 (10.5 g, 15.3 mmol) deaerated for 10 minutes by bubbling with argon was dropped into this at 80°C over a period of 5 minutes, and the mixture was stirred at the same temperature for 6 hours. Thereafter, the reaction product was extracted using hexane (200 mL). The resultant organic layer was washed with saturated saline, dried over anhydrous magnesium sulfate, and filtrated. The resultant filtrate was concentrated by an evaporator, then, the solvent was distilled off. The resultant residue was purified by silica gel column chromatography using a mixed solvent of hexane and chloroform as a moving bed, to obtain 2.73 g of a compound 15. The yield was 56.8%.
¹H-NMR (300 MHz, CDCl₃) : δ (ppm)= 7.24 (d, 2H), 7.14 (d, 2H), 6.74 (d, 2H), 3.67 (s, 6H), 3.26-3.20 (m, 4H), 1.73-1.57 (m, 8H), 1.38-1.04 (m, 110H), 0.93-0.83 (m, 12H).

### Synthesis Example 11

### (Synthesis of compound 16)

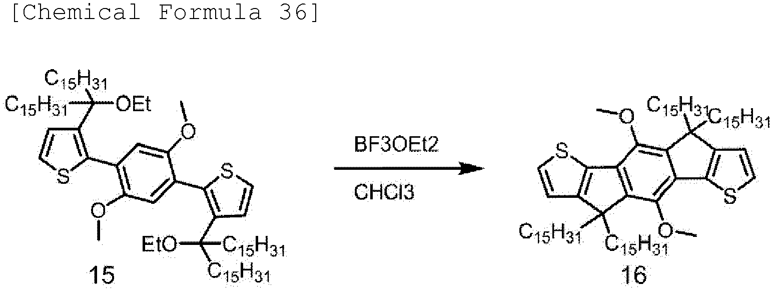

A nitrogen gas atmosphere was prepared in a reaction vessel, then, the compound 15 (6.30 g, 5.0 mmol) and dry chloroform (50 mL) were added. Thereafter, to this was added boron trifluoride diethyl ether complex (2.5 mL, 20.0 mmol), and the mixture was stirred at 50°C for 6 hours. Thereafter, water was added at room temperature, and the organic layer was extracted. The resultant organic layer was washed with water, dried over anhydrous magnesium sulfate, and filtrated. The resultant filtrate was concentrated by an evaporator, then, the solvent was distilled off. The resultant residue was purified by silica gel column chromatography using hexane as a mobile phase, to obtain 3.32 g of a compound 16. The yield was 56.8%.
¹H-NMR (300 MHz, CDCl₃) : δ (ppm) = 7.31 (d, 2H), 6.93 (d, 2H), 3.97 (s, 6H), 2.22-2.12 (m, 4H), 2.09-1.99 (m, 4H), 1.31-0.75 (m, 116H).

### Synthesis Example 12

### (Synthesis of compound 17)

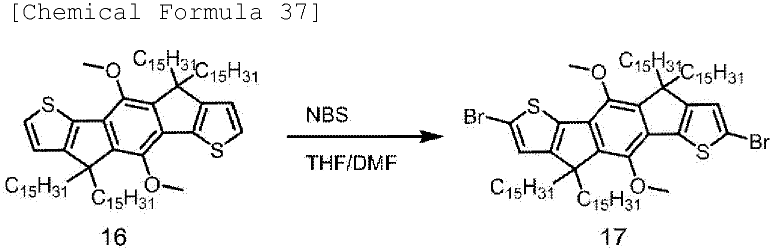

A nitrogen gas atmosphere was prepared in a reaction vessel, then, the compound 16 (2.66 g, 2.18 mmol) and dry THF (220 mL) were added. Thereafter, to this was added N-bromosuccinic imide (0.855 g, 4.80 mmol) at room temperature, and the mixture was stirred for 3 hours at room temperature. Thereafter, to this were added a saturated sodium thiosulfate aqueous solution (2 mL) and water (100 mL), and the mixture was stirred for 5 minutes, then, the reaction product was extracted using hexane. The resultant organic layer was washed with water, dried over anhydrous magnesium sulfate, and filtrated. The resultant filtrate was concentrated by an evaporator, then, the solvent was distilled off. The resultant residue was purified by silica gel column chromatography using hexane as a moving bed, and recrystallized using a mixed solvent of hexane and methanol, to obtain 2.62 g of a compound 17. The yield was 79.0%.
¹H-NMR (300 MHz, CDCl₃) : δ (ppm) = 6.94 (s, 2H), 3.91 (2, 6H), 2.19-2.08 (m, 4H), 2.03-1.92 (m, 4H), 1.35-0.70 (m, 116H).

### Example 2

### (Synthesis of polymer compound C)

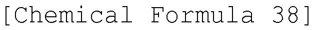

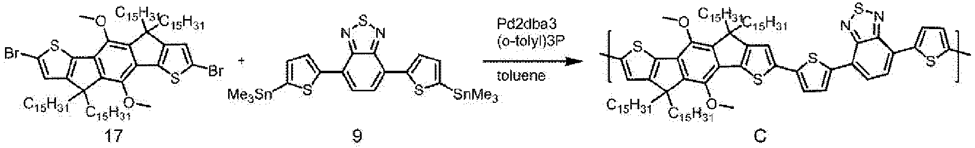

A nitrogen gas atmosphere was prepared in a reaction vessel equipped with a reflux tube, then, the compound 17 (198.9 mg, 0.15 mmol), a compound 9 (93.9 mg, 0.15 mmol) and dry toluene (15 mL) were added, and deaerated for 10 minutes by bubbling with an argon gas. Thereafter, to this were added tris(dibenzylideneacetone)dipalladium(0) (6.9 mg, 7.5 µmol) and tri(o-tolyl)phosphine (9.1 mg, 30 µmol). The resultant reaction solution was heated up to 100°C, then, stirred for 3 hours. The reaction liquid was cooled down to room temperature, purified by a silica gel column, then, the resultant toluene solution was dropped into methanol, to obtain a solid. The resultant solid was filtrated, washed in a Soxhlet extractor using acetone as a solvent, and dried to obtain a polymer compound C. The amount gained was 210.8 mg, and the polystyrene-equivalent number-average molecular weight thereof was 7.0×10⁴ and the weight-average molecular weight thereof was 1.5×10⁵.

### Synthesis Example 13

### (Synthesis of polymer compound E)

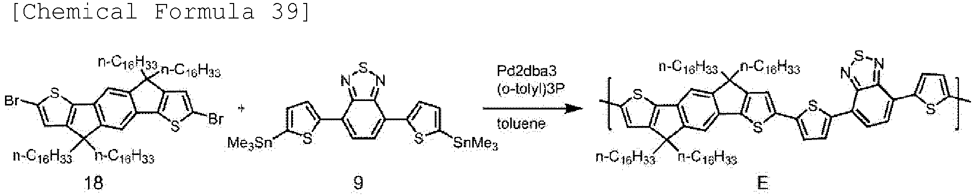

A nitrogen gas atmosphere was prepared in a reaction vessel equipped with a reflux tube, then, a compound 18 (178.5 mg, 0.135 mmol), a compound 9 (84.5 mg, 0.135 mmol) and dry toluene (15 mL) were added, and deaerated for 10 minutes by bubbling with an argon gas. Thereafter, to this were added tris(dibenzylideneacetone)dipalladium(0) (6.2 mg, 6.7 µmol) and tri(o-tolyl)phosphine (8.2 mg, 27 µmol).

The resultant reaction solution was heated up to 100°C, then, stirred for 3 hours. The reaction liquid was cooled down to room temperature, and purified by a silica gel column, then, the resultant toluene solution was dropped into methanol, to obtain a solid. The resultant solid was filtrated, washed in a Soxhlet extractor using acetone as a solvent, and dried, to obtain a polymer compound E. The amount gained was 151.8 mg, and the polystyrene-equivalent number-average molecular weight thereof was 2.0×10⁴ and the weight-average molecular weight thereof was 5.1×10⁴.

### Example 3

### (Fabrication and evaluation of organic film solar battery 1)

The polymer compound A and fullerene C70PCBM (phenyl C71-butyric acid methyl ester) (Phenyl C61-butyric acid methyl ester, manufactured by Frontier Carbon Corporation) as an electron accepting compound were dissolved at a weight ratio of polymer compound A/C70PCBM=1/3 in orthodichlorobenzene, and the resultant solution was filtrated through a teflon (registered trademark) filter having a pore size of 0.45 µm, to prepare an ink 1 (the sum of the polymer compound A and C70PCBM was 2.0 wt%).

A glass substrate carrying patterned ITO with a thickness of 150 nm formed by a sputtering method was washed with an organic solvent, an alkali detergent and ultrapure water, and dried. Thereafter, the glass substrate was treated with UV-O₃ using an ultraviolet-ozone (UV-O₃) apparatus.

Next, a PEDOT:PSS solution (manufactured by HeraeusCleviosP VP AI4083) was filtrated through a filter having a pore size of 0.45 µm. The PEDOT:PSS solution after filtration was spin-coated on the ITO side of the substrate to form film with a thickness of 50 nm. Thereafter, the film was heated on a hot plate at 120°C for 10 minutes in atmospheric aid, to form an organic layer functioning as a hole transporting layer.

Next, the above-described ink 1 was spin-coated on the organic layer of the substrate to form an active layer with a thickness of 107 nm.

Next, calcium was vapor-deposited with a thickness of 4 nm, then, silver was vapor-deposited with a thickness of 100 nm by a vacuum vapor deposition machine, to fabricate an organic film solar battery 1 as a photoelectric conversion device. The degree of vacuum in metal vapor deposition was 1.0×10⁻³ to 9×10⁻³Pa. The resultant organic film solar battery 1 had a shape of 2 mm × 2 mm square.

The organic solar battery 1 obtained above was irradiated with constant light using Solar Simulator (manufactured by Bunkoukeiki Co., Ltd., trade name: OTENTO-SUNII: AM 1.5 G filter, irradiance: 100 mW/cm²), and generating current and voltage were measured and fill factor was determined. The fill factor was 0.624. The results are shown in Table 1.

### Example 4

### (Fabrication and evaluation of organic film solar battery 2)

An ink 2 was prepared in the same manner as in Example 3, excepting that the polymer compound C was used instead of the polymer compound A, and an active layer was formed with a thickness of 78 nm by spin coating, and an organic film solar battery 2 was fabricated and evaluated. The fill factor was 0.646. The results are shown in Table 1.

### Comparative Example 1

### (Fabrication and evaluation of organic film solar battery 4)

An ink 3 was prepared in the same manner as in Example 3, excepting that the polymer compound E was used instead of the polymer compound A, and an active layer was formed with a thickness of 108 nm by spin coating, and an organic film solar battery 3 was fabricated and evaluated. The fill factor was 0.539. The results are shown in Table 1.

**[Table 1]**

| | | |
|---|---|---|
| | | fill factor |
| Example 3 | organic film solar battery 1 (polymer compound A) | 0.624 |
| Example 4 | organic film solar battery 2 (polymer compound C) | 0.646 |
| Comparative Example 1 | organic film solar battery 3 (polymer compound E) | 0.539 |

### Explanation of numerals

1: substrate
2: active layer
7a: first electrode
7b: first electrode
300: photoelectric conversion device

### Industrial Applicability

According to the present invention, a polymer compound which is useful for production of an organic film solar battery excellent in fill factor can be produced.

## Claims

1. A polymer compound comprising a structural unit represented by the formula (1): 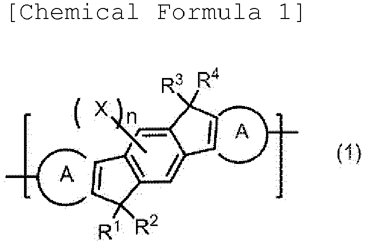 [wherein
R¹, R², R³ and R⁴ each independently represent an alkyl group, an aryl group or a monovalent heterocyclic group, and these groups optionally have a substituent.
Two rings A may be the same or different, and represent a thiophene ring, a benzothiophene ring or a thienothiophene ring. n represents 1 or 2, and X represents a halogen atom, an alkyl group, an alkoxy group, an alkylthio group, an amino group, an aryl group, a monovalent heterocyclic group, an alkenyl group or an alkynyl group, and these groups optionally have a substituent. When n is 2, two groups X may be the same or different.].

2. The polymer compound according to Claim 1, wherein the structural unit represented by the formula (1) is a structural unit represented by the formula (2): 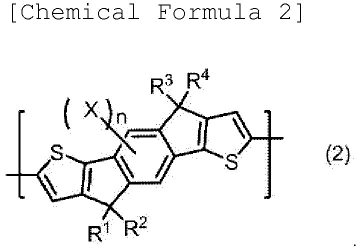 [wherein R¹, R², R³, R⁴, n and X represent the same meaning as described above.].

3. An organic film comprising the polymer compound according to Claim 1 or 2.

4. An organic semiconductor device comprising a first electrode, a second electrode and the organic film according to Claim 3.

5. The organic semiconductor device according to Claim 4, wherein the device is any of a photoelectric conversion device, an organic transistor, an organic electroluminescent device, an organic field effect type transistor sensor and an organic conductivity modulation type sensor.

6. The organic semiconductor device according to Claim 5, wherein the device is a photoelectric conversion device.
